# EUROPÄISCHE PATENTSCHRIFT

(11) **EP 1 027 157 B1**
(45) Veröffentlichungstag und Bekanntmachung des Hinweises auf die Patenterteilung: **06.08.2003**
(21) Anmeldenummer: 98961111.6
(22) Anmeldetag: 29.10.1998
(51) Int. Cl.: B01J 37/00

(54) **NANOSTRUKTUREN**
NANOSTRUCTURES
NANOSTRUCTURES

(30) Priorität: 29.10.1997 DE 19747816; 29.10.1997 DE 19747815; 19.09.1998 DE 19843411
(43) Veröffentlichungstag der Anmeldung: 16.08.2000
(73) Patentinhaber: Universität Ulm, 89081 Ulm (DE)
(72) Erfinder: SPATZ, Joachim, D-89520 Heidenheim (DE); MÖLLER, Martin, D-89081 Ulm (DE); HERZOG, Thomas, D-91717 Wassertrudingen (DE); MÖSSMER, Stefan, D-73312 Geislingen (DE); ZIEMANN, Paul, D-89155 Erbach (DE)
(74) Vertreter: Müller-Boré & Partner Patentanwälte
(86) Internationale Anmeldenummer: EP9806874
(87) Internationale Veröffentlichungsnummer: WO99021652

(56) Entgegenhaltungen:
- SPATZ J P ET AL: "NOBLE METAL LOADED BLOCK IONOMERS: MICELLE ORGANIZATION, ADSORPTIONOF FREE CHAINS AND FORMATION OF THIN FILMS" ADVANCED MATERIALS, Bd. 7, Nr. 8, 1. August 1995, Seiten 731-735, XP000519827
- SPATZ J P ET AL: "GOLD NANOPARTICLES IN MICELLAR POLY(STYRENE)-B-POLY(ETHYLENE OXIDE)FILMS - SIZE AND INTERPARTICLE DISTANCE CONTROL IN MONOPARTICULATE FILMS" ADVANCED MATERIALS, Bd. 8, Nr. 4, 1. April 1996, Seiten 337-340, XP000587111
- WANG Z L: "STRUCTURAL ANALYSIS OF SELF-ASSEMBLING NANOCRYSTAL SUPERLATTICES" ADVANCED MATERIALS, Bd. 10, Nr. 1, 2. Januar 1998, Seiten 13-30, XP000727815
- A.BADIA ET AL.: "Gold-Sulfur interactions in Alkylthiol Self-Assembled Monolayers formed on Gold nanoparticles Studied by Solid-State NMR" JOURNAL OF THE AMERICAN CHEMICAL SOCIETY., Bd. 119, Nr. 45, 12. November 1997, Seiten 11104-11105, XP002099522 DC US
- SELVAN S T ET AL: "GOLD-POLYPYRROLE CORE-SHELL PARTICLES IN DIBLOCK COPOLYMER MICELLES" ADVANCED MATERIALS, Bd. 10, Nr. 2, 22. Januar 1998, Seiten 132-134, XP000727856
- SCHMITT H ET AL: "THE EFFECT OF TERMINAL HYDROGEN BONDING ON THE STRUCTURE AND DYNAMICS OF NANOPARTICLE SELF-ASSEMBLED MONOLAYERS (SAMS): AN NMR DYMANICS STUDY" ADVANCED MATERIALS, Bd. 10, Nr. 6, 16. April 1998, Seiten 475-480, XP000750499
- M. BRUST ET AL.: "Synthesis of Thiol-derivated Gold Nanoparticles in a Two-phases Liquid-liquid System" JOURNAL OF THE CHEMICAL SOCIETY, CHEMICAL COMMUNICATIONS.,1994, Seiten 801-802, XP002099523 LETCHWORTH GB
- M. BRUST ET AL.: "Synthesis and reactions of Fonctionalised Gold Nanoparticles" JOURNAL OF THE CHEMICAL SOCIETY, CHEMICAL COMMUNICATIONS.,1995, Seiten 1655-1656, XP002099524 LETCHWORTH GB
- J.P. SPATZ: "Ion-Stabilized Copolymer Micelle: Film Formation and Intermicellar Interaction" MACROMOLECULES., Bd. 29, 1996, Seiten 3220-3226, XP002099525 EASTON US

## Beschreibung

Die vorliegende Erfindung betrifft die Strukturierung und Dekorierung von Substraten im Nanometerbereich. Insbesondere betrifft die vorliegende Erfindung oberflächendekorierte Substrate, welche darauf im Nanometerbereich geordnete Oberflächenstrukturen aus Metall und/oder Metalloxidclustern und/oder Halbleiterclustern aufweisen, ein Verfahren zu deren Herstellung und deren Verwendung zur Epoxidierung von C₃-C₈-Alkenen bzw. zur Oxidation von CO zu CO₂ sowie oberflächenstrukturierte Substrate, die im Nanometerbereich über makroskopische Bereiche strukturiert sind, insbesondere Pt, Au, GaAs, In_{y}GaAs, AlₓGaAs, Si, SiO₂, Ge, SiₓN_{y}, SiₓGaAs, InP, InPSi, GaInAsP, Glas, Graphit, Diamant, Glimmer, SrTiO₃ oder deren dotierte Modifikationen, und ein Verfahren zu deren Herstellung. Die Erfindung basiert auf der Filmbildung von Kern-Schale-Polymersystemen, deren Kernbereiche in Lösung selektiv mit entsprechenden Metallverbindungen modifiziert bzw. beladen werden und die in dünnen Filmen regelmäßig angeordnete Strukturen ausbilden. Diese auf der Substratoberfläche abgeschiedenen Filme können selektiv so geätzt werden, daß die organische Polymerkomponente vollständig entfernt wird und dabei das Substrat durch die anorganischen Rückstände in einer regelmäßigen Anordnung dekoriert wird. Weiterhin können die strukturierten Filme als Masken dienen, die es ermöglichen, das Substrat selektiv zu ätzen und so eine durch den Film vorgegebene Struktur in das Substrat zu übertragen.

Fein disperse Edelmetallkatalysatoren bilden die Grundlage wichtiger chemischer Verfahren, wie z.B. die Hydrierung, die selektive Oxidation von Alkenen, Alkinen und Aromaten zu Alkoholen, Epoxiden, Ketonen, Aldehyden und Carbonsäuren, die Oxidation von CO, die Zerlegung von Stickoxiden (NOₓ) in Stickstoff und ein entsprechendes Oxidationsprodukt (H₂O, CO₂) und die Umsetzung von Methan mit Kohlendioxid zu Synthesegas (CO/H₂).

Wichtiges Kriterium für die Aktivität und Selektivität der Katalysatoren ist, daß das Metallteilchen auf einem geeigneten, zumeist oxidischen Träger aufgebracht ist. So ist zum Beispiel reines Gold im Gegensatz zu den Metallen der Platingruppe katalytisch inert, in Verbindung mit einem oxidischen Träger verfügt man hingegen über ein katalytisch hochaktives System. Der Wahl des oxidischen Trägers kommt dabei eine entscheidende Rolle für die Aktivierung und Restrukturierung der katalytisch aktiven Teilchenoberfläche während des Katalysezyklus zu. Die Struktur des Trägers und seine chemische Wechselwirkung mit dem Edelmetall wirkt sich nachhaltig auf Aktivität und Selektivität des Katalysators aus. Die Abscheidung von Platinschichten auf sulfidischen oder oxidischen Trägern mit wohldefinierter Oberflächenstruktur führt zu maßgeschneiderten, hochaktiven Katalysatorsystemen. Zeolithe mit variabler, aber genau definierter Porenstruktur führen zu einer Erhöhung der aktiven Oberfläche und in Verbindung mit dem "richtigen" Edelmetall zu einer Steigerung sowohl der Selektivität, als auch der Aktivität. In modernen Dreiwegekatalysatoren wird neben dem Edelmetall (Pt, Pd, Rh) und dem Träger (SiO₂, Al₂O₃) CeO₂ als Promotor verwendet, welches den für die Reaktion notwendigen Sauerstoff speichert und freigibt. Gegenüber Katalysatoren ohne Promotoren wird dadurch der katalytische Prozess entscheidend verbessert.

Neben der Oberflächenbeschaffenheit und Art des Trägers spielt in Hinblick auf die Stabilität und Effektivität der Katalysatoren auch die Größe und der Abstand von Edelmetallteilchen eine überaus wichtige Rolle.

Eine hohe katalytische Aktivität sollte jedoch insbesondere mit Teilchengrößen von kleiner als 5 nm erzielt werden. Die regelmäßige Anordnung von 1 bis 3 nm großen Edelmetallteilchen auf einem Träger in einem kostengünstigen Verfahren gilt dabei als wichtiges Ziel für die Weiterentwicklung heterogener Katalysatorsysteme.

Periodische und aperiodische Mikrostrukturen von einigen Mikrometern bis einigen 100 Nanometern werden für eine Vielzahl von Anwendungen, insbesondere für elektronische und optische Bauelemente, Sensoren und in der Mikrotechnologie mittels lithographischer Techniken hergestellt.

Für Strukturierungen über 180 nm waren bisher optische Lithographieverfahren sehr erfolgreich. Da dies ein paralleles Verfahren ist, welches zudem einen großen Durchsatz erlaubt, dominiert es eindeutig die Produktion mikroelektronischer Schaltkreise. Die erreichbare minimale Strukturgröße ist durch einen technischen Kompromiß zwischen der physikalisch möglichen Auflösung und der apparativ erforderlichen Tiefenschärfe bestimmt. In der Produktion liegen die Abmessungen integrierter Schaltkreise bereits standardmäßig unter 350 nm. Die Verwendung von Röntgenlicht unter technisch sehr hohem Aufwand erreicht Dimensionen von ca. 90 nm.

Mit der Elektronenstrahl- und lonenstrahllithographie kann man schon seit längerem Strukturen mit Nanometer-Abmessungen herstellen, und entsprechende Anlagen sind im Handel erhältlich. Die Atomstrahllithographie erlaubt durch die Kontrolle der Wechselwirkung der Atomstrahlen mit Lichtmasken, großflächig periodische Linienmuster und verschiedene zweidimensionale periodische Strukturen mit einer Auflösung unter 100 nm zu erzeugen. Dabei werden Atome entweder direkt auf einem Substrat deponiert oder zur Modifikation organischer Resists genutzt.

Diese weitere Reduzierung der geometrischen Dimensionen ermöglicht nicht nur eine weitere Minitiarisierung, sondern erlaubt auch die Nutzung dimensionsabhängiger physikalischer Eigenschaften, wie z.B. Quanteneffekte, superferromagnetische Eigenschaften oder Elektronenplasmonenresonanzen. Grundsätzlich erfordert die Umsetzung in makroskopische Effekte oder Meßgrößen aber eine hohe Einheitlichkeit eines Ensembles von mikroskopischen Strukturen.

Für die in diesem Zusammenhang interessanten Strukturen unterhalb von 100 nm ist die Anwendung herkömmlicher lithographischer Verfahren äußerst schwierig und wenig wirtschaftlich. Komplementär zu herkömmlichen Verfahren müssen hierzu neue Verfahren entwickelt werden, die entweder auf einem größenkontrollierten Wachstum anorganischer Strukturen oder auch auf molekularen Konzepten der organischen und makromolekularen Chemie beruhen. Hierzu sind bisher nur wenige Beispiele bekannt:
1) Durch Ausnützung des Kristallwachstums auf GaAs(31 1)B-orientierten Substraten konnten nicht nur kleine Einheiten, sondern auch wohlgeordnete Quantendotstrukturen dargestellt werden. Nach dem Wachstum einer dünnen InGaAs-Schicht über eine AlGaAs-Pufferschicht bricht der verspannte InGaAs-Film in kleine Stücke auf, die spontan unter AlGaAs vergraben werden. So bilden sich auf natürliche Weise geordnete Reihen von AlGaAs-Mikrokristallen mit einem Kern aus scheibenförmigen InGaAs-Dots. Größe und Abstand der Dots lassen sich dabei unabhängig voneinander allein durch die Wachstumsparameter kontrollieren. Die Photolumineszensspektren der Dots sind durch hohe Effizienz und schmale Linienbreiten gekennzeichnet.
2) Ein Zwei- oder Multiblockcopolymer besteht aus chemisch unterschiedlichen makromolekularen Ketten, welche an den Enden oder an einer anderen molekularen Position (beispielsweise im Fall von Stern- oder Propfblockcopolymeren) kovalent verbunden sind. In den meisten Fällen mischen sich die unterschiedlichen Blöcke nicht miteinander und separieren in sogenannten Mikrodomänen. Deren Größe und morphologische Ordnung wird unter anderem von den Volumenanteilen der einzelnen Blöcke und der Molekulargewichtsverteilung bestimmt. So erlaubt die Änderung des Volumenanteils der Polymerblöcke die Einstellung unterschiedlicher Mikrodomänenstrukturen wie z.B. Kugeln, Zylinder und Lamellen. Typischerweise betragen die damit erreichbaren Perioden zwischen 10 und 200 nm.

Aufgrund der chemischen und physikalischen Unterscheidbarkeit der verbundenen makromolekularen Blöcke können die chemisch unterschiedlichen Mikrodomänen selektiv durch andere Komponenten beladen bzw. markiert werden. Dies gelingt z.B. durch die Aufnahme von Lösungsmittel oder durch eine selektive Reaktion mit einem Übergangsmetall. Letzteres wird sehr häufig zur Kontrastierung von Polymeren in der Elektronenmikroskopie eingesetzt.

Eine Mikrophasenseparation kann auch in ultradünnen Filmen beobachtet werden. Entscheidend ist hierbei, inwieweit die Mikrodomänenstruktur und deren Organisation von den Grenzflächen- und Oberflächenenergien und der geometrischen Einengung beeinflußt wird.

Adv. Mater. 1996, Nr. 4, Seiten 337 bis 340, beschreibt Mizellensysteme bildende A-B-Diblockcopolymerfilme wie z.B. Poly(styrol)-b-Poly(ethylenoxid)-Filme, wobei die Mizellen mit anorganischen Precursormolekülen wie HAuCl₄ beladen werden, die anschließend unter Beibehaltung der Mizellensysteme bildenden A-B-Diblockcopolymerfilme innerhalb der Mizelle zu Nanopartikeln umgewandelt werden.

Adv. Mater. 1995, Nr. 8, Seiten 731 bis 735, beschreibt die Selbstorganisation Mizellen-bildender A-B-Diblockcopolymerfilme wie z.B. Poly(styrol)-b-Poly(vinylpyridin)-Filme, wobei die Mizellen mit anorganischen Precursormolekülen wie HAuCl₄ beladen sind.

Park et al. beschreiben das Übertragen der Mikrodomänenstruktur eines Zweiblockcopolymers auf ein unterliegendes Siliziumnitridsubstrat (Park et al., Science 1997, 276, 1401 sowie Appl. Phys. Lett. 1996, 68, 2586). Zwei unterschiedliche Techniken, basierend auf einer reaktiven Ionenätzung, erlauben die Herstellung von Löchern mit 20 nm Durchmesser mit einer Periodizität von 40 nm sowie die entsprechende inverse Struktur. In gleicher Weise konnten zusammenhängende Kanäle von 30 nm Durchmesser und 15 nm Abstand auf ein Substrat übertragen werden. Dabei wurden Mikrodomänenbereiche aus Polybutadien eines Polystyrol-b-Polybutadien Zweiblockcopolymers mit Ozongas versetzt und aus der Polystyrolmatrix ausgelöst oder mit Osmiumatomen markiert. Beide Verfahren resultieren in einer lokalen Inhomogenität bezüglich des Ätzwiderstandes, was letztendlich ermöglicht, Zweiblockcopolymermuster als Maske für nanometergroße Oberflächenstrukturen einzusetzen. Solche Muster im Bereich einiger Nanometer können prinzipiell für die Herstellung von Nanostrukturen und für den Einsatz als Masken für die Lithographie technologisch nutzbar werden.

Nachteilig ist jedoch für die im Stand der Technik beschriebenen Verfahren, daß sie ökonomisch nicht vertretbar sind und/oder auf sehr spezielle Systeme beschränkt sind.

Somit liegt der vorliegenden Erfindung die Aufgabe zugrunde, ein auf Grundlagen der organischén bzw. makromolekularen Chemie basierendes, vielseitig einzusetzendes Konzept zu entwickeln, welches die Strukturierung und die Dekorierung von Substraten im Nanometerbereich erlaubt. Insbesondere sollen ein Verfahren, welches die Oberflächendekorierung von Substraten im Nanometerbereich durch geordnete Abscheidung definierter Metall- bzw. Metalloxidcluster auf einem Substrat erlaubt, sowie mit solchen definierter Metall- bzw. Metalloxidclustern oberflächendekorierte Substrate, die sich zur Verwendung als Katalysatoren zur Epoxidierung von C₃-C₈-Alkenen bzw. zur Oxidation von CO zu CO₂ eignen sollen, bereitgestellt werden. Ein solches Verfahren soll insbesondere die kontrollierte Darstellung von Verbundclustern aus einer katalytisch aktiven Metallkomponente und einem Metalloxid ermöglichen, wobei die relativen Anteile systematisch variiert werden können. Des weiteren sollen ein auf molekularen Konzepten der organischen bzw. makromolekularen Chemie basierendes ökonomisches bzw. effizientes Verfahren, welches die Oberflächenstrukturierung von Substraten im Nanometerbereich (bevorzugt kleiner als 20 nm, mehr bevorzugt kleiner als 5 nm) über makroskopische Bereiche erlaubt, sowie im unteren Nanometerbereich strukturierte Substrate bereitgestellt werden, die sich durch ein großes Tiefe-Breite-Verhältnis auszeichnen sollen, d.h. die Höhen- und Tiefenabmessungen der Strukturen sollen die lateralen Dimensionen um ein Vielfaches übertreffen.

Diese Aufgabe wird durch die in den Ansprüchen gekennzeichneten Ausführungsformen gelöst.

Inbesondere wird in einem ersten Aspekt der vorliegenden Erfindung ein Verfahren zur Herstellung von oberflächendekorierten Substraten bereitgestellt, umfassend die Schritte:
(a) Aufnehmen eines Polymers in einem geeigneten Lösungsmittel unter Bildung eines gelösten Kern-Schale-Polymersystems,
(b) Beladen von mindestens einem Teil der Polymerkerne mit einer oder mehreren, gleichen oder unterschiedlichen Metallverbindungen,
(c) Aufbringen des in Schritt (b) erhaltenen, beladenen Kern-Schale-Polymersystems als Film derart auf mindestens eine Seite eines Substrats, daß das Kern-Schale-Polymersystem in einer regelmäßigen Struktur im Film angeordnet ist, und
(d) Entfernen des das Kern-Schale-Polymersystem aufbauenden Polymers unter Erzeugung von Metallclustern und/oder Clustern von Metallverbindungen auf der Substratoberfläche ohne wesentliche Änderung der durch das Kern-Schale-Polymersystem aufgebauten Struktur.

In einer bevorzugten Ausführungsform dieses Verfahrens zur Oberflächendekorierung von Substraten im Nanometerbereich wird bzw. werden vor Schritt (c) die im Polymerkern enthaltende(n) Metallverbindung(en) durch chemische Behandlung und/oder durch energiereiche Strahlung, beispielsweise UV-Licht, Röntgenstrahlung oder Elektronenbeschuß, in Lösung oder im Film in das Metall oder ein Metalloxid überführt. Im Schritt (d) dieses erfindungsgemäßen Verfahrens wird das Polymer vorzugsweise mittels eines Ätz-, Reduktions- oder Oxidationsprozesses entfernt. Mehr bevorzugt wird die Ätzbehandlung mittels eines reaktiven Plasmas, vorzugsweise ein Sauerstoffplasma, durchgeführt.

Dieses erfindungsgemäße Verfahren gemäß dem ersten Aspekt der vorliegenden erfindung erlaubt überraschenderweise sehr einfach die geordnete Abscheidung diskreter Metall- oder Metalloxidcluster auf unterschiedlichen Substraten unter Ausbildung regelmäßiger bzw. geordneter Nanostrukturen. Auch Halbleitercluster von beispielsweise Si und Ge können nach dem erfindungsgemäßen Verfahren sehr einfach hergestellt werden. Das erfindungsgemäße Verfahren erlaubt ferner auf Basis der mizellaren Systeme aus amphiphilen Blockcopolymeren die geordnete Abscheidung kleinster, katalytisch hochaktiver Metallteilchen auf einem nahezu beliebigen Substrat.

In einem zweiten Aspekt der vorliegenden Erfindung wird ein Verfahren zur Herstellung von oberflächenstrukturierten Substraten bereitgestellt, umfassend die Schritte:
(a) Aufnehmen eines Polymers in einem geeigneten Lösungsmittel unter Bildung eines gelösten Kern-Schale-Polymersystems,
(b) Beladen von mindestens einem Teil der Polymerkerne mit einer oder mehreren, gleichen oder unterschiedlichen Metallverbindungen,
(c) Aufbringen des in Schritt (b) erhaltenen Kern-Schale-Polymersystems als Film derart auf mindestens eine Seite eines Substrats, daß das Kern-Schale-Polymersysteme in einer regelmäßigen Struktur im Film angeordnet ist, und
(d) Unterwerfen des in Schritt (c) erhaltenen Substrats einem reaktiven lonenätzverfahren, einem lonensputterverfahren oder einem naßchemischen Verfahren oder einer Kombination davon, wobei der auf dem Substrat aufgebrachte Film entfernt wird, und worin die durch das Kern-Schale-Polymersystem erzeugte, regelmäßige Struktur aufgrund und in Abhängigkeit von der Art der Beladung der Polymerkerne sowie der Dauer des reaktiven lonenätzverfahrens und/oder des lonensputterverfahrens und/oder des naßchemischen Verfahrens in eine Reliefstruktur des Substrats überführt wird.

In einer bevorzugten Ausführungsform dieses erfindungsgemäßen Verfahrens zur Oberflächenstrukturierung von Substraten im Nanometerbereich wird vor dem Aufbringen als Film oder nach der Filmbildung mindestens ein Teil der in den Polymerkernen enthaltenen Metallverbindungen durch chemische Behandlung und/oder energiereiche Strahlung, beispielsweise UV-Licht, Röntgenstrahlung oder Elektronenbeschuß, zu einem oder mehreren Metall- und/oder Metalloxidteilchen in jedem einzelnen Polymerkern überführt.

Durch dieses erfindungsgemäße Verfahren können Oberflächenstrukturen, wie Löcher, Stege, Gräben und punktförmige Erhöhungen mit einer Breite bzw. Durchmesser zwischen vorzugsweise 1 bis 100 nm und einer Tiefe bzw. Höhe, welche die lateralen Dimensionen bis zu einem Vielfachen übersteigen kann, in einem entsprechenden Substrat erzeugt werden. Diese Oberflächenstrukturen werden auch als Reliefstrukturen im Substrat bezeichnet.

Unter dem Ausdruck "Kern-Schale-Polymersystem", wie hier verwendet, sind beispielsweise makromolekulare Amphiphile zu verstehen, welche in wäßriger oder organischer Lösung assoziieren und wohldefinierte kugelförmige bzw. stäbchenförmige Mizellen, Lamellen, Vesikel oder komplexe Aggregate bilden können. Erfindungsgemäß sind damit auch solche, allgemein als Wirt/Gast-Systeme bezeichnete Systeme eingeschlossen, in denen ein von dem eingesetzten Polymer (Wirtsverbindung) erzeugter Molekülhohlraum bzw. Molekülinnenraum, d.h. der Polymerkern, mit einem Gastverbindung, d.h. der verwendeten Metallverbindung, beladen bzw. komplexiert werden kann.

Das in den Verfahren erfindungsgemäß eingesetzte Polymer, welches in Lösung ein solches Kern-Schale-Polymersystem aufbaut, ist vorzugsweise aus Blockcopolymeren, Pfropfcopolymeren, Miktoarmsternpolymeren, Sternpolymeren mit unterschiedlichen Armen, dentritischen Polymeren, Mikrogelteilchen, Sternblockpolymeren, Blocksternpolymeren und Kern-Schale-Latexpolymeren ausgewählt.

Mehr bevorzugt ist das Polymer Polystyrol-b-polyethylenoxid, Polystyrol-bpoly(2-vinylpyridin), Polystyrol-b-poly(4-vinylpyridin) oder ein Gemisch davon. Der Polystyrolblock darin kann aber auch durch andere nicht-polare Polymere, wie beispielsweise Polyisopren, Polybutadien, Polymethylmethacrylat oder andere Polymethacrylate ersetzt werden. Der zweite bzw. polare Block in einem solchen Zweiblockcopolymer kann ein solcher sein, der eine möglichst starke Wechselwirkung mit der eingesetzten Metallverbindung eingeht. Beispiele hierfür sind Polyacrylsäure, Polymethacrylsäure, aminosubstituierte Polystyrole, Polyacrylate bzw. Polymethacrylate, aminosubstituierte Polydiene, Polyethylenimine, verseifte Polyoxazoline oder hydriertes Polyacrylnitril. Der erste Block kann auch aus einem polaren Polymer aufgebaut sein, jedoch mit der Maßgabe, daß dann die Metallverbindung derart gewählt ist, daß diese hauptsächlich, d.h. selektiv, mit dem zweiten polaren Block wechselwirkt.

Typischerweise werden die vorgenannten Polymersysteme in einem selektiven Lösungsmittel, wie z.B Toluol, in einer Menge von etwa 10⁻³ bis etwa 100 mg/ml, vorzugsweise etwa 5 mg/ml, gelöst. Nach mehreren Stunden, beispielsweise etwa 12 Stunden, wird in Schritt (b) der erfindungsgemäßen Verfahren die Lösung mit einer oder mehreren Metallverbindungen versetzt und für mehrere Stunden, beispielsweise etwa 24 Stunden, stark gerührt, um mindestens einen Teil der durch das Kern-Schale-Polymersystems gebildeten Polymerkerne mit der/den Metallverbindung(en) zu beladen.

Solche Metallverbindungen sind beispielsweise Verbindungen von Au, Pt, Pd, Ag, In, Fe, Zr, Al, Co, Ni, Ga, Sn, Zn, Ti, Si und Ge in den entsprechenden Oxidationsstufen oder Gemische davon. Spezifische Beispiele sind HAuCl₄, MeAuCl₄, wobei Me ein Alkalimetall bedeutet, H₂PtCl₆, Pd(Ac)₂, Ag(Ac), AgNO₃, lnCl₃, FeCl₃, Ti(OR)₄, TiCl₄, TiCl₃, CoCl₃, NiCl₂, SiCl₄, GeCl₄, GaH₃, ZnEt_{2,} Al(OR)₃, Zr(OR)₄, Si(OR)₄, wobei R einen geradkettigen oder verzweigten C₁-C₈-Alkylrest bedeutet, Ferrocen, Zeisesalz und SnBu₃H oder Gemische davon. Vorzugsweise ist die Metallverbindung HAuCl₄. Typische Einwaagen sind 0,01 bis 2,0 molekulare Vorstufeneinheiten pro Monomereinheit des polaren Polymerblocks.

In Schritt (c) der erfindungsgemäßen Verfahren wird das Aufbringen des Films in Mono- oder Multischichten auf mindestens eine Seite eines Substrats vorzugsweise durch Tauch-, Gieß-, Spinschleuderverfahren oder durch Adsorption aus verdünnter Lösung durchgeführt. Mehr bevorzugt wird das Aufbringen in Monooder Multischichten durch Tauchverfahren in verdünnter Lösung durchgeführt. Die Filme werden beispielsweise durch definiertes Ziehen eines Substrates aus der Lösung mit Geschwindigkeiten zwischen beispielsweise 0,001 mm/min und 2 m/min erzielt. Solche makroskopisch deckende Filme weisen eine Schichtdicke von beispielsweise einer oder mehreren beladenen Zweiblockcopolymermizellen, d.h. 5 bis 800 nm, auf. Beispielsweise weist ein monomizellarer Film demgemäß die Schichtdicke einer Mizelle auf. Die mit der Metallverbindung und/oder den Metallteilchen beladenen Polymerkerne, d.h. beispielsweise die Mizellen oder entsprechende Molekülhohlräume, werden dabei unter Ausbildung einer regelmäßigen Struktur im Film im wesentlichen intakt abgeschieden. Die Polymerkerne, die entweder mit der Metallverbindung als Vorstufe für die Reduktion zum entsprechenden Metall oder bereits mit den entsprechenden metallischen- oder metalloxidischen Teilchen beladen sind, ordnen sich dabei selbständig in einer regelmäßigen Struktur auf der Substratoberfläche an.

Verwendbare Substrate sind Edelmetalle, oxidische Gläser, mono- oder multikristalline Substrate, Halbleiter, Metalle mit oder ohne passivierter Oberfläche, Isolatoren oder allgemein Substrate mit hoher Resistenz gegen die nachfolgenden Ätzprozeduren. Insbesondere handelt es sich hierbei um Pt, Au, GaAs, In_{y}GaAs, AlₓGaAs, Si, SiO₂, Ge, SiₓN_{y}, SiₓGaAs, InP, InPSi, GaInAsP, Glas, Graphit, Diamant, Glimmer, SrTiO₃ sowie deren dotierte Modifikationen. Die verwendbaren Substrate können sowohl planare, ebene Substrate (z. B. Glimmerplättchen mit einer Länge von < 15 µm) als auch solche mit planaren, gekrümmten (konvex oder konkav) Oberflächen (bsp. Mikroglas- oder Mikroquarzkugeln mit Durchmessern von z.B. 1 bis 50 µm) sein.

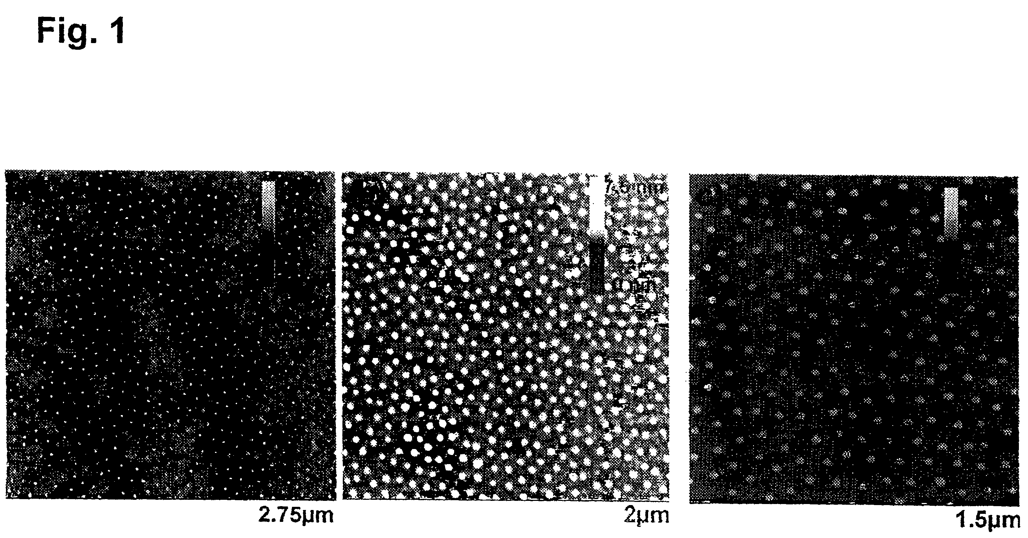

Die Belegungsdichte wird durch das Molekulargewicht der amphiphilen Blockcopolymere, die Größe der Teilchen sowohl durch den Polymerisationsgrad des eine regelmäßige Struktur bildenden (bsp. mizellbildenden) Blocks als auch durch die Beladungsmenge mit einer metallischen Vorstufe in Lösung eingestellt, wobei die Teilchendurchmesser beispielsweise von 1 bis 20 nm und der Teilchen-Teilchenabstand von 20 bis 400 nm, vorzugsweise 20 bis 200 nm, betragen. Die Einheitlichkeit der Cluster, wie gemäß dem Verfahren des ersten Aspekts der vorliegenden Erfindung erhalten, und deren regelmäßige Anordnung wird durch die homogene Verteilung der Salze in Lösung auf die Mizellen und durch die einheitliche Größenverteilung der Zweiblockcopolymermizellen erzielt (vgl. Fig. 1). Diese durch das Kern-Schale-Polymersystem aufgebaute Struktur bzw. Ordnung, wobei mindestens ein Teil der Polymerkerne selektiv durch ein oder mehrere Metallverbindung markiert bzw. beladen ist, wird im jeweilig nachfolgenden Schritt (d) nicht beeinträchtigt.

Wie oben ausgeführt, wird im Schritt (d) gemäß dem Verfahren des ersten Aspekts der vorliegenden Erfindung das Kern-Schale-Polymersystem aufbauende Polymer unter Erzeugung von Metallclustern und/oder Clustern von Metallverbindungen auf der Substratoberfläche vollständig entfernt, ohne daß die durch das Kern-Schale-Polymersystem aufgebaute Struktur bzw. die Anordnung der Cluster auf der Substratoberfläche im wesentlichen geändert wird. Das Polymer wird dabei beispielsweise mittels eines Ätz-, Reduktions- oder Oxidationsprozesses entfernt. Die vorgenannten Prozesse können dabei auch bei erhöhter Temperatur durchgeführt werden. Insbesondere wird die Ätzbehandlung mittels eines reaktiven Plasmas, vorzugsweise ein Sauerstoffplasma, durchgeführt. Reaktive Gas-Plasma-Verfahren (CF₄, H₂, SFₓ) oder die Oxidation in einer oxidierenden Atmosphäre bei einer erhöhten Temperatur, die Ätzung durch energiereiche Strahlung, insbesondere durch elektromagnetische Strahlen oder Teilchenstrahlen wie Elektronenstrahlen, oder pyrrolitische Prozesse können ebenfalls zur Entfernung der Polymerhülle eingesetzt werden.

Durch die vorgenannten Techniken in Schritt (d) des erfindungsgemäßen Verfahrens gemäß dem ersten Aspekt wird die organische Polymerhülle an der gewünschten Stelle bzw. an dem gewünschten Bereich rückstandsfrei entfernt und die metallischen Vorstufe in ihre kristalline Me bzw. MeOₓ -Modifikation in Form von Agglomerationen von kleinen Me- bzw. MeOₓ-Teilchen, sogenannten Nanoclustern, überführt.

Die abgeschiedenen Cluster sind, abhängig von den in Schritt (b) eingesetzten Metallverbindungen, insbesondere sauerstoffresistente Edelmetalle, wie Au, Pt, Pd, oder Oxide, z.B. halbleitende Oxide wie TiO₂, oder magnetische Teilchen, wie z.B. bestimmte Modifikationen von Fe₂O₃, Fe, Co oder Ni.

Die Abscheidung von metallischen Mischsystemen wie Au/Fe₂O₃, Au/CoO, Au/Co₃O₄, Au/ZnO, Au/TiO₂, Au/ZrO₂, Au/Al₂O₃, Au/In₂O₃, Pd/Al₂O₃, Pd/ZrO₂, Pt/Al₂O₃ und Pt/Graphit gelingt durch Versetzen einer Lösung eines erfindungsgemäß verwendeten Polymersystems mit einem Gemisch der jeweiligen Metallverbindungen.

Beispielsweise werden für die Abscheidung von "nackten" Metall/Metalloxid Clustern die von einem der vorgenannten Polymesysteme aufgebauten, metallsalzhaltigen Mizellen in Form eines ultradünnen Films auf dem gewählten Substrat aufgebracht, anschließend wird die Polymerhülle durch die Behandlung mit einem Sauerstoffplasma, durch Abbrennen in einer sauerstoffreichen Atmosphäre, durch Pyrolyse oder auch unter reduzierenden Bedingungen, z. B. in einem Wasserstoffplasma selektiv entfernt.

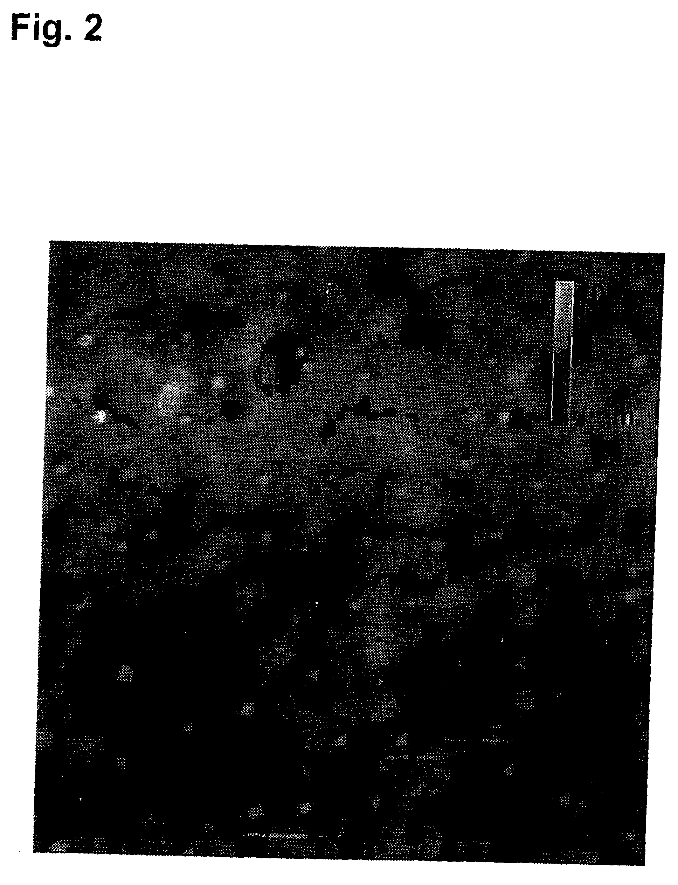

Bei dieser Behandlung wird die Übergangsmetallverbindung zum elementaren Metall oder unter oxidierenden Bedingungen zum metalloxidischen Teilchen umgesetzt. Die thermische Reduktion oder Umsetzung von Edelmetallverbindungen in Sauerstoffatmosphäre erzeugt eine ähnlich enge Teilchenverteilung wie das Abbrennen des Polymers mittels des oben beschriebenen Plasmaprozesses (vgl. Fig. 2).

Nach dem oben beschriebenen Verfahren können insbesondere Gold-, Platin-, Palladium-, Nickel-, Titandioxid-, Eisenoxid- und Cobaltoxidcluster verschiedener Größe dargestellt werden.

Oberflächenmethodische Untersuchungen belegen die Abscheidung von beispielsweise Au, Pt, In, Co, Ni, Pd, TiO₂, Fe₂O₃ sowie deren jeweiligen Mischsysteme, insbesondere Au/Fe₂O₃, Au/CoO, Au/Co₃O₄, Au/ZnO, Au/TiO₂, Au/ZrO₂, Au/Al₂O₃, Au/In₂O₃, Pd/Al₂O₃, Pd/ZrO₂, Pt/Al₂O₃ und Pt/Graphit. Die Cluster-Durchmesser können durch Variation der Einwaage der entsprechenden Metallverbindung als Vorstufe zur entsprechenden Lösung des Kern-Schale-Polymersystems beispielsweise zwischen 0,5 nm und 100 nm eingestellt werden. Die Periodiziät bzw. Oberflächenbelegung der auf der Substratoberfläche regelmäßig angeordneten Me/MeOₓ-Cluster kann durch den Polymerisationsgrad des anfänglich eingesetzten Polymersystems beispielsweise zwischen 10 nm, vorzugsweise 20 nm, und 400 nm eingestellt werden.

Überraschenderweise können durch das erfindungsgemäße Verfahren, welches auf der Selbstorganisation eines Kern-Schale-Polymersystems basiert, das als Templat zur regelmäßigen Abscheidung von Me- und/oder MeOₓ-Clustern fungiert, im Nanometerbereich oberflächendekorierte Substrate sehr einfach und ökonomisch hergestellt werden.

Die durch das erfindungsgemäße Verfahren erhaltbaren, mit Metall- und/oder Metalloxid-Clustern im Nanometerbereich oberflächendekorierten Substrate umfassen auf mindestens einer Seite Cluster von Metallatomen und/oder Metallverbindungen, wobei die Cluster einen Durchmesser von vorzugsweise 0,5 bis 100 nm aufweisen und mit einem Abstand von vorzugsweise bis zu 400 nm regelmäßig auf der Substratoberfläche angeordnet sind. Diese Nanocluster können insbesondere Gold-, Platin-, Palladium-, Titandioxid-, Eisenoxid- und Cobaltoxidcluster sein. Die erfindungsgemäßen oberflächendekorierten Substrate können auch Cluster aus beispielsweise Au/Fe₂O₃, Au/CoO, Au/Co₃O₄, Au/ZnO, Au/TiO₂, Au/ZrO₂, Au/Al₂O₃, Au/In₂O₃, Pd/Al₂O₃, Pd/ZrO₂, Pt/Graphit oder Pt/Al₂O₃ aufweisen. Bevorzugte Substrate sind Pt, Au, GaAs, In_{y}GaAs, AlₓGaAs, Si, SiO₂, Ge, SiₓN_{y}, SiₓGaAs, InP, InPSi, GaInAsP, Glas, Graphit, Diamant, Glimmer, SrTiO₃ oder deren dotierte Modifikationen.

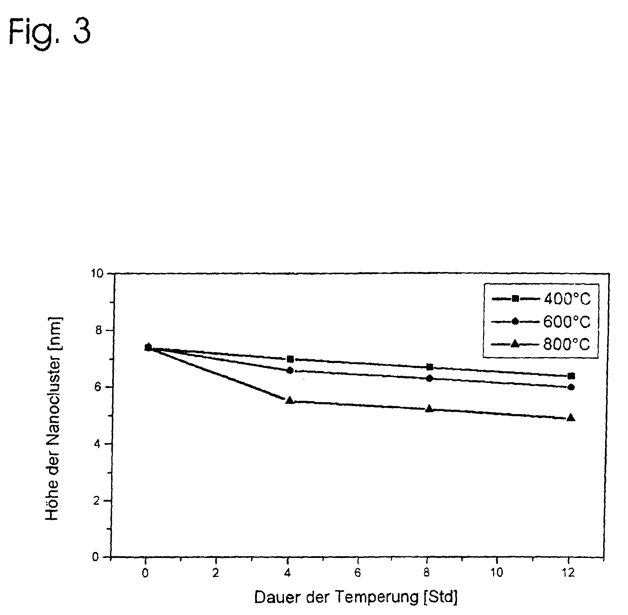

Die durch das erfindungsgemäße Verfahren hergestellten, mit Metall- und/oder Metalloxid-Clustern im Nanometerbereich oberflächendekorierten Substrate, d.h. die Nanoteilchen, zeichnen sich neben ihrer hohen Einheitlichkeit auch durch ihre hohe Temperaturbeständigkeit aus. Bei der Temperung von 7,5 nm hohen Goldteilchen wird auch bei längerer thermischer Belastung nur eine geringfügige Abnahme der Höhe beobachtet. Dies ist in Figur 3 aufgetragen. Die geringfügige Abnahme oberhalb T = 400°C kann durch die Umwandlung von primär gebildetem Goldoxid zu Gold erklärt werden.

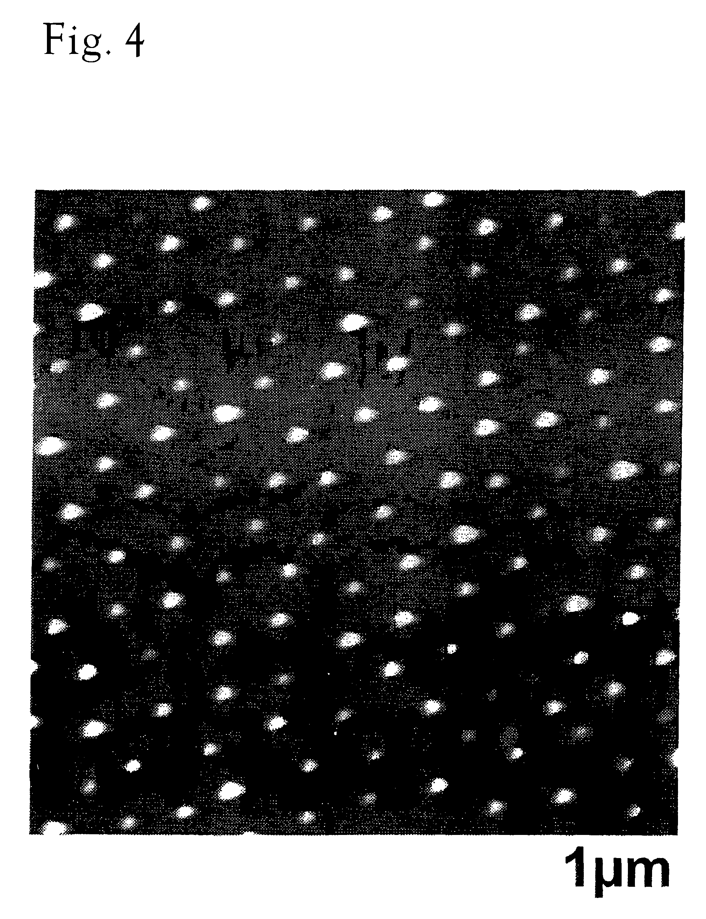

Die Ordnung bleibt dabei auch nach zwölfstündiger Temperung bei T = 800°C erhalten, wie mittels AFM-Aufnahmen belegt werden kann (vgl. Fig. 4).

Neben der hohen thermischen Belastbarkeit wird auch eine hohe chemische Resistenz der Nanopartikel beobachtet. Ist die Teilchenbildung vollzogen, sind die Nanocluster gegenüber schwefelsauren oder chloridhaltigen Lösungen stabil, was für chemische Umsetzungen an diesen Nanoedelmetallclustern vorteilhaft ist.

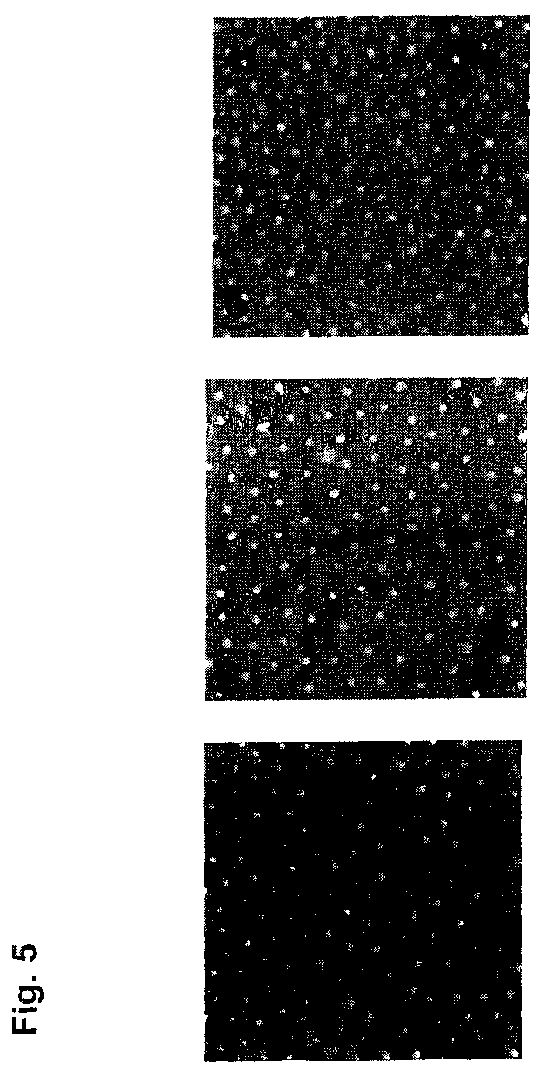

Gemäß einer Ausführungsform des erfindungsgemäßen Verfahrens können die Blockcopolymermizellen auch mit unterschiedlichen metallischen Salzen in Lösung beladen werden. Diese Mischsysteme werden in die Mizellen hochdispers eingebaut, wie mittels Elektronenenergieverlust-Spektroskopie nachgewiesen werden kann. Jede Mizelle ist dabei homogen mit beiden anorganischen Komponenten beladen. Die erfindungsgemäße Abscheidung der Hybridsysteme und anschließende Gasplasmabehandlung führt zu "nackten", hochdispersen Mischclustern, wie z.B. Au/TiO₂, Au/Fe₂O₃ oder Au/Co₃O₄ auf verschiedenen Substraten. Kraftmikroskopische Aufnahmen von monomizellaren Filmen nach einer Gasplasmabehandlung zeigen regelmäßig geordnete und gleichgroße Nanocluster, wie in Fig. 5 dargestellt.

Ein weiterer Gegenstand der vorliegenden Erfindung ist die Verwendung der vorgenannt definierten oberflächendekorierten Substrate zur Epoxidierung von C₃-C₈-Alkenen oder zur Oxidation von CO zu CO₂.

Wie bereits ausgeführt, ist die Oxidationskatalyse von CO zu CO₂ ein wichtiger Anwendungsbereich für Edelmetalle, aufgebracht auf Metalloxide (Au/TiO₂, Au/Fe₂O₃, Pt/Al₂O₃ oder Au/Co₃O₄). Dieser Prozess ist u.a. in der Brennstoffzellentechnologie von Bedeutung. Die Katalyse findet an der Grenzfläche Edelmetall/oxidischer Träger statt. Insbesonders bei Brennstoffzellen, welche mit Methanol betrieben werden, wird der Wasserstoff durch den sogenannten "steam-reforming-Prozess" erhalten. Es entsteht zu 75% Wasserstoff, zu 25% Kohlendioxid und in Spuren Kohlenmonoxid. Der Restgehalt an Kohlenmonoxid vergiftet jedoch die Anodenkatalysatoren. Deshalb muß der CO-Gehalt durch selektive Oxidation zu CO₂ vermindert werden.

Generell wird eine hohe katalytische Aktivität bei geringem Edelmetallverbrauch angestrebt. Dies wird durch die Verwendung kleinster Teilchen und damit einer erhöhten aktiven Oberfläche und in der heterogenen Katalyse durch eine maximale Grenzfläche zwischen Edelmetall und Metalloxid erreicht.

Der spezifische Katalysator hat dabei großen Einfluß auf die Aktivierungsenergie der Oxidation; vgl. nachstehende Tabelle 1.

**Tab. 1:**

| Aktivierungsenergie für die Reaktion CO → CO₂ im Falle heterogener Systeme | | |
|---|---|---|
| Edelmetall | Träger | Aktivierungstemperatur [°C] |
| Pd | Al₂O₃ bzw. ZrO₂ | 150-200 |
| Pt | Graphit bzw. Al₂O₃ | 150-200 |
| Au | Al₂O₃ | 150-200 |
| Au | TiO₂ | ca. 80 |

Au/Fe₂O₃ oder Au/TiO₂ zeigen bei ca. 80°C die gleiche katalytische Aktivität und Selektivität wie Pt/Al₂O₃ bei 150-200°C. lnsbesonders bei Methanol-Brennstoffzellen ist eine Aktivierungstemperatur unter 100°C grundlegend.

Edelmetallteilchen spielen neben der Hydrierung auch als Oxidationskatalysatoren eine wichtige Rolle. Die Oxidation von Ethylen mit molekularem Sauerstoff an Silberkolloiden wird technisch zur Herstellung von Ethylenoxid verwendet. Als Promotor werden Salze der Alkali- (bevorzugt Cäsiumverbindungen) bzw. Erdalkalimetalle eingesetzt. Dieser Prozess ist jedoch auf das System Ethylen- Ethylenoxid beschränkt und bislang nicht auf längerkettige Alkene anwendbar. in diesem Zusammenhang beschreibt die europäische Patentanmeldung EP-A1-0 709 360 nach der herkömmlichen Kopräzipitationsmethode hergestellte Metall/Metalloxid-Katalysatoren zur Epoxidierung von höheren Alkenen.

Im Zuge des vorstehend gekennzeichneten, erfindungsgemäßen Verfahrens gemäß dem ersten Aspekt der vorliegenden Erfindung lassen sich durch Aufbringen der mizellstabilisierten Edelmetallteilchen auf einen oxidischen Träger (z.B.SiO₂) heterogene Katalysatoren herstellen, welche sich gegenüber homogenen Systemen durch höhere Stabilität, Aktivität und Selektivität auszeichnen und eine hohe katalytische Aktivität bei geringem Edelmetallverbrauch aufweisen. Durch Verwendung der Blockcopolymermizellen gemäß dem vorstehend gekennzeichneten, erfindungsgemäßen Verfahren kann die Teilchengröße, der Partikel-Partikel-Abstand und die daraus resultierende aktive Oberfläche genau eingestellt werden. Durch die rückstandsfreie Entfernung des Polymers und gleichzeitige Umwandlung der Metallsalze durch den Gasplasmaprozess resultieren dabei wohldefinierte Metall/Metalloxidverbundsysteme auf verschiedenen Substraten, wie beispielsweiser Glimmer, Glas oder Quarz.

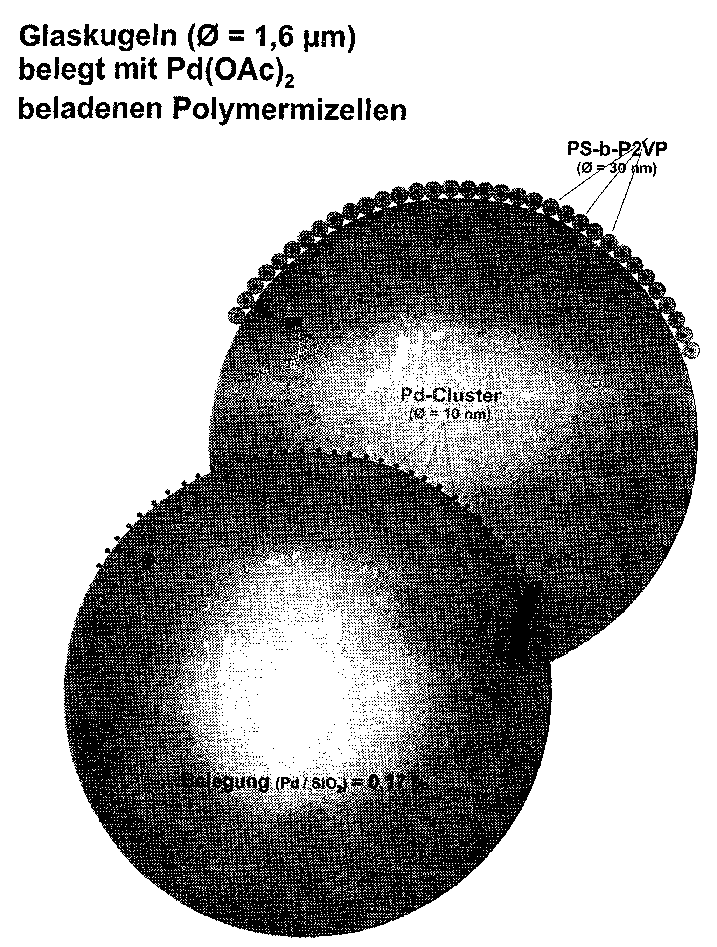

Um eine gute Filmbildung zu erreichen, können die Mizellen beispielsweise auf einem planaren Substrat aufgebracht werden; vgl. Fig. 6. Beispielsweise können als Träger Mikroglas- oder Mikroquarzkugeln oder Glimmerplättchen mit glatter Oberfläche eingesetzt werden, da für solche Mikrokugel die spezifische Oberfläche des Trägers und die Menge an Edelmetall gut berechenbar ist. Der Gewichtsanteil an Edelmetall ist dabei kleiner als für herkömmliche Pulverkatalysatoren üblich.

**Tabelle 2:**

| Beladung von Glaskugeln mit Pd-Cluster (5 nm Größe) | | |
|---|---|---|
| Glaskugel [µm] | m(Pd)/m(Kugel) [mg/g] | % Pd/Kat. |
| 1000 | 0,0027 | 0,00027 |
| 100 | 0,027 | 0,0027 |
| 10 | 0,27 | 0,027 |
| 5 | 0,5 | 0,05 |
| 1,6 | 1,7 | 0,17 |
| 1 | 2,7 | 0,27 |

In Abhängigkeit der Größe der Glaskugeln ergeben sich unterschiedliche Werte für die Menge an Edelmetall, die für den katalytischen Prozess zur Verfügung steht. Üblicherweise sind für Katalysatoren auf Basis Palladium/Träger Werte von 1-10 Gew.-% Edelmetall Standard. Im Ansatz mit Blockcopolymermizellen ist ein so hoher Gehalt an Edelmetall nicht erreichbar, aber eben auch nicht zwingend notwendig, da sich Größe und Abstand der Nanoteilchen mit diesem Konzept genau einstellen lassen. Dadurch wird auch bei niedrigerer Edelmetallmenge eine gleiche oder zumindest ähnliche katalytische Aktivität erreicht.

Im erfindungsgemäßen Verfahren gemäß dem zweiten Aspekt kann die auf die Polymerkerne einheitlich verteilte Einwaage in Lösung durch einen Reduktionsoder Oxidationsprozeß und/oder durch energiereiche Strahlung zu einem einzelnen oder zu mehreren metallischen- oder metalloxidischen Teilchen in jedem einzelnen Polymerkern umgewandelt werden oder durch Zugabe einer geeigneten Komponente in dem Polymerkern ausgefällt werden, wobei die Kern-Schale-Struktur des eingesetzten Polymersystems direkten Einfluß auf die Größe der in den Kern-Schale-Polymersystemen gebildeten Teilchen besitzt.

Dabei wird mindestens ein Teil der in den Polymerkernen enthaltenen Metallverbindungen in Lösung durch einen Reduktions- oder Oxidationsprozeß zu einem oder mehreren Metall- und/oder Metalloxidteilchen in jedem einzelnen Polymerkern in einem solchen Ausmaß überführt, daß ein Teil der beladenen Polymerkerne ein oder mehrere Metallatome und/oder ein oder mehrere Metallverbindungen enthält. Wird beispielsweise HAuCl₄ als Metallverbindung eingesetzt, so können die Au³⁺-Ionen, mit welchen die Polymerkerne des verwendeten Kern-Schale-Polymersystems beladen werden, in Lösung durch einen Reduktionsoder Oxidationsprozeß in einem solchen Ausmaß reduziert werden, daß ein Teil der beladenen Polymerkerne ein oder mehrere Goldatome und ein oder mehrere Au³⁺-Ionen enthält. Wird eine solche Reduktion der die Polymerkerne beladenen Metallverbindungen in Lösung durchgeführt, so wird vorzugsweise Hydrazin als Reduktionsmittel verwendet.

In Schritt (d) dieses erfindungsgemäßen Verfahrens gemäß dem zweiten Aspekt wird der Film zusammen mit dem vom Film mindestens teilweise bedeckten Substrats einem reaktiven lonen-ätzverfahren, einem lonensputterverfahren oder einem naßchemischen Verfahren oder einer Kombination davon unterworfen. Die auf der Substratoberfläche abgeschiedenen Strukturen dienen dabei als Maske, die durch Ätztechniken in das entsprechende Substrat übertragen werden, wobei der auf dem Substrat aufgebrachte Film rückstandsfrei an der gewünschten Stelle bzw. dem gewünschten Bereich entfernt wird, und worin die durch das Kern-Schale-Polymersystem erzeugte, regelmäßige Struktur aufgrund und in Abhängigkeit von der Art der Beladung der Polymerkerne sowie der Dauer des reaktiven lonenätzverfahrens und/oder des lonensputterverfahrens und/oder des naßchemischen Verfahrens in eine Reliefstruktur des Substrats überführt wird. Vorzugsweise wird ein lonenätzen mit Argon, Ozon, Sauerstoff und deren Mischungen durchgeführt, mehr bevorzugt ist ein Argonionen-Sputtern.

Je nach Dauer des Ätzprozesses und in Abhängigkeit von der Beladung der Polymerkerne wird der auf dem Substrat aufgebrachte Film derart weggeätzt, daß in Abhängigkeit davon auch das verwendete Substrat abgetragen wird, so daß durch das erfindungsgemäße Verfahren gemäß dem zweiten Aspekt der vorliegenden Erfindung oberflächenstrukturierte Substrate erhalten werden, welche eine Reliefstruktur mit lateralen Dimensionen zwischen vorzugsweise 1 und 100 nm über makroskopische Bereiche aufweisen. insbesondere können dadurch in den Substraten Löcher, Gräben, Stege, punktförmige Erhöhungen sowie deren inverse Strukturen mit lateralen Dimensionen zwischen beispielsweise 1 und 100 nm selbst über große makroskopische Bereiche erzeugt werden. Die dabei erreichten Höhen- und Tiefenabmessungen der Strukturen können die lateralen Dimensionen um ein Vielfaches übertreffen, beispielsweise um das 20 bis 100-fache.

Liegen beispielsweise einerseits mit Goldatomen beladene Mizellen und andererseits mit einer Goldverbindung beladene Mizellen bzw. Molekülhohlräume neben unbeladenen Mizellen in dem auf dem Substrat abgeschiedenen Film vor, so werden in Abhängigkeit von der Beladung selektiv zuerst die mit Goldatomen beladenen Mizellen unter Bildung von beispielsweise Löchern, dann die nichtbeladenen Mizellen und zuletzt die mit einer Goldverbindung beladenen Mizellen unter Bildung von beispielsweise Inseln durch beispielsweise Ar-Sputterverfahren weggeätzt, wodurch die im abgeschiedenen Film vorgegebene, regelmäßige Struktur, welche als Maske fungiert, durch die Ätztechniken in das entsprechende Substrat in Form einer Reliefstruktur übertragen wird.

Die Figuren zeigen:
Fig. 1 zeigt rasterkraftmikroskopische Aufnahmen erfindungsgemäßer, im Nanometerbereich oberflächendekorierter Substrate: a) ⌀_{Pt} = 7 nm auf Quarzglas; b) ⌀_{Pd} = 5 nm auf Glimmer; c) ⌀_{Au} = 8 nm auf Glas.
Fig. 2 zeigt eine rasterkraftmikroskopische Aufnahme von 8 nm hohen Au-Nanoclustern auf Glas nach thermischer Behandlung in einer Sauerstoffatmosphäre (T = 200°C, p(O₂) = 0,5 bar, t = 120 min.), wobei die Länge einer Bildkante 1 µm entspricht.
Fig. 3 zeigt die Abhängigkeit von 7,5 nm hohen Goldclustern auf Glas von der Temperdauer für drei unterschiedliche Temperaturen.
Fig. 4 zeigt eine rasterkraftmikroskopische Aufnahme erfindungsgemäßer, im Nanometerbereich oberflächendekorierter Substrate, wobei Goldcluster auf Glas nach der Sauerstoffplasmabehandlung 12 Stunden bei T = 800°C unter normaler Atmosphäre getempert wurden.
Fig. 5 zeigt rasterkraftmikroskopische Aufnahmen von Gold/Metalloxid-Hybridsystemen auf Glas: a) 5 nm hohe Gold/Titandioxid-Cluster; b) 5 nm hohe Gold/Cobaltoxid-Cluster; c) 5 nm hohe Gold/Eisenoxidcluster nach der Sauerstoffplasmabehandlung. Die Länge einer Bildkante entspricht 1 µm.
Fig. 6 zeigt die schematische Darstellung der Dimensionen Mizelle (metallcluster) vs. Mikroglaskugel (obere Kugel: vor der Entfernung der Polymerhülle; untere Kugel: nach der Entfernung der Polymerhülle).
Fig. 7 zeigt rasterkraftmikroskopische Aufnahmen von erfindungsgemäßen, im Nanometerbereich oberflächendekorierten Substraten gemäß Beispiel 1, wobei nackte Goldcluster auf Glimmer abgeschieden wurden; (a) ⌀_{Au} = 12 nm, Periodizität = 80 nm; (b) ⌀_{Au} = 3 nm, Periodizität = 25 nm; (c) ⌀_{Au} = 1 nm, Periodizität = 140 nm.
Fig. 8 zeigt eine rasterkraftmikroskopische Aufnahme eines erfindungsgemäßen, im Nanometerbereich oberflächendekorierten Substrats gemäß Beispiel 2, wobei nackte Goldcluster auf einem Si-Wafer abgeschieden wurden; ⌀_{Au} = 3 nm, Periodizität = 120 nm.
Fig. 9 zeigt eine rasterkraftmikroskopische Aufnahme eines erfindungsgemäßen, im Nanometerbereich oberflächendekorierten Substrats gemäß Beispiel 3, wobei nackte Goldcluster auf GaAs abgeschieden wurden; ⌀_{Au} = 3 nm, Periodizität = 70 nm.
Fig. 10 zeigt rasterkraftmikroskopische Aufnahmen von erfindungsgemäßen, im Nanometerbereich oberflächendekorierten Substraten gemäß Beispiel 4, wobei nackte Goldcluster auf SrTiO₃ abgeschieden wurden; ⌀_{Au} = 3 nm, Periodizität = 120 nm; (a) vor dem Tempern, (b) nach dem Tempern bei 800°C in einer Ar/O₂-Atmosphäre.
Fig. 11 zeigt eine rasterkraftmikroskopische Aufnahme eines erfindungsgemäßen, im Nanometerbereich oberflächendekorierten Substrats gemäß Beispiel 5, wobei nackte Goldcluster auf einem Diamantfilm abgeschieden wurden; ⌀_{Au} = 3 nm, Periodizität = 120 nm.

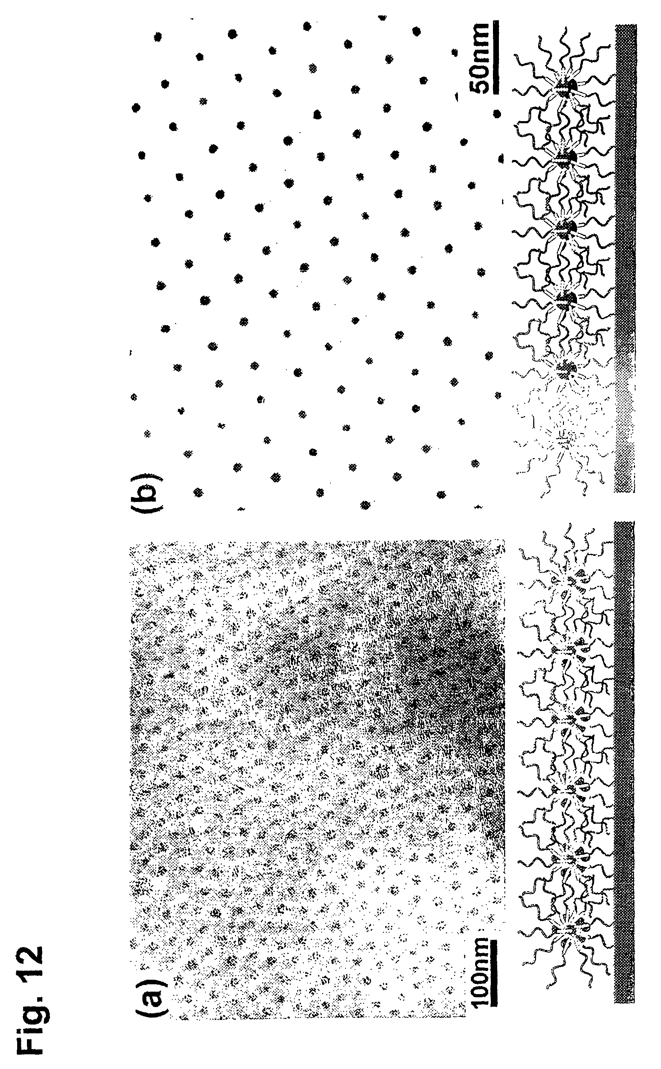

Fig. 12 zeigt transmissionselektronenmikroskopische (TEM)-Aufnahmen von monomizellaren Filmen gemäß Beispiel 8, bestehend aus (a) Poly[styrol]₆₄₀-b-Poly[ethylenoxid)(LiAuCl₄)_{0,3}]₂₂₀ -Mizellen, wobei die Au³⁺-Ionen durch Elektronenstrahlung im Film reduziert wurden, und (b) Poly[styrol]₃₀₀-b-Poly[(2-vinylpyridin)(HAuCl₄)_{0,5}]₃₀₀, wobei das Au³⁺-Ion in Lösung zu Au umgewandelt und das Wachstum von einem, im Durchmesser ca. 6 nm großen Kristall in jeder einzelnen Mizelle vor der Filmbildung induziert wurde. Den jeweiligen TEM-Aufnahmen folgen schematischen Darstellungen der jeweiligen Filme.
Fig. 13 zeigt eine rasterkraftmikroskopische Aufnahme eines monomizellaren Polymerfilms von Poly[styrol]₁₇₀₀-b-Poly[(2-vinylpyridin)(HAuCl₄)_{0,4}]₄₅₀ -Mizellen auf einem Si-Wafer gemäß Beispiel 9. Die Länge einer Bildkante beträgt 2,5 µm.
Fig. 14 zeigt rasterkraftmikroskopische Aufnahmen der nach dem erfindungsgemäßen Verfahren strukturierten GaAs-Wafer gemäß Beispiel 10: (a) 400 Löcher und (b) 400 Inseln. Die Länge einer Bildkante beträgt 1,25 µm.

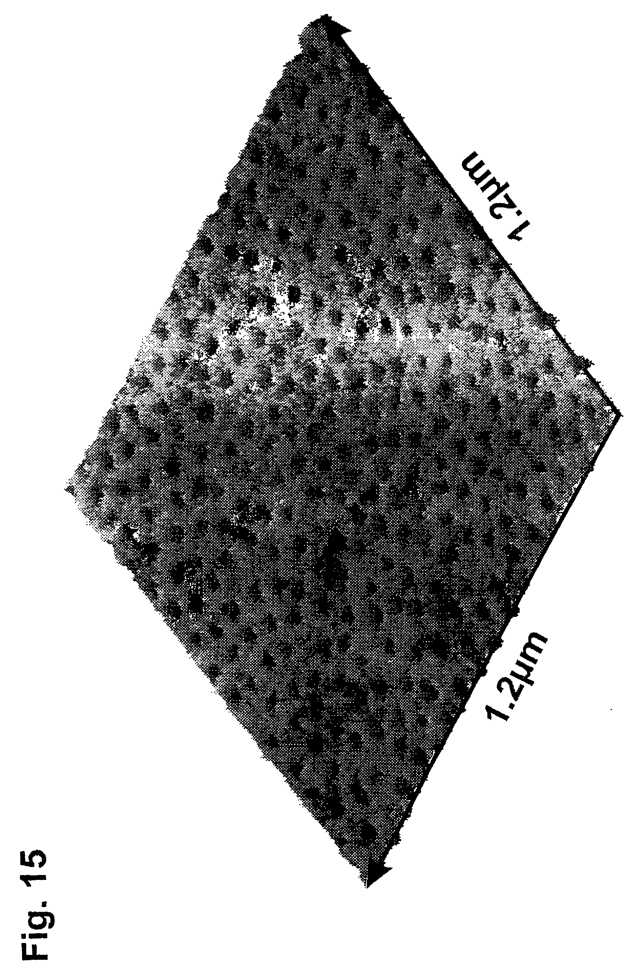

Fig. 15 zeigt die 3-dimensionale Struktur von 400 Löchern in dem nach dem erfindungsgemäßen Verfahren strukturierten GaAs-Wafer gemäß Beispiel 10.
Fig. 16 zeigt rasterkraftmikroskopische Aufnahmen eines nach dem erfindungsgemäßen Verfahren strukturierten GaAs-Reliefs gemäß Beispiel 11; (a) Topographie und (b) Reibung. Die Länge einer Bildkante beträgt 2 µm.
Fig. 17 zeigt weitere rasterkraftmikroskopische Aufnahmen eines nach dem erfindungsgemäßen Verfahren strukturierten GaAs-Reliefs gemäß Beispiel 11; (a) Topographie und (b) Abweichung des Amplitudensignals. Die Länge einer Bildkante beträgt 1,25 µm.
Fig. 18 zeigt das Höhenrelief eines geätzten GaAs-Wafers gemäß Beispiel 11 im Profil.
Fig. 19 zeigt eine rasterkraftmikroskopische Aufnahme eines erfindungsgemäßen, im Nanometerbereich oberflächendekorierten Substrats gemäß Beispiel 12, wobei nackte Cobaltcluster auf einem Si-Wafer abgeschieden wurden; ⌀_{Co} = 12 nm, Periodizität = 80 nm. Daneben ist das magnetische Moment der Cobaltcluster bei T = 50 K gegen das Magnetische Feld aufgetragen.
Fig. 20 zeigt eine rasterkraftmikroskopische Aufnahme eines erfindungsgemäßen, im Nanometerbereich oberflächendekorierten Substrats gemäß Beispiel 13, wobei nackte Nickelcluster auf einem Glimmersubstrat abgeschieden wurden; ⌀_{Ni} = 6 nm, Periodizität = 140 nm.
Fig. 21 zeigt eine rasterkraftmikroskopische Aufnahme eines erfindungsgemäßen, im Nanometerbereich oberflächendekorierten Substrats gemäß Beispiel 14, wobei nackte Goldcluster auf einem Si-Wafer abgeschieden wurden; ⌀_{Au} = 8 nm, Periodizität = 100 nm.
Fig. 22 zeigt eine rasterkraftmikroskopische Aufnahme eines erfindungsgemäßen, im Nanometerbereich oberflächendekorierten Substrats gemäß Beispiel 15, wobei nackte Platincluster auf einem Goldeinkristall-Substrat (100) abgeschieden wurden; ⌀_{Pt} = 4 nm, Periodizität = 40 nm.
Fig. 23 zeigt eine dreidimensionale Darstellung von InGaAs-Quantenpunkten auf einem nach dem erfindungsgemäßen Verfahren strukturierten GaAs-Wafer gemäß Beispiel 16.

Die vorliegende Erfindung wird nachstehend durch Beispiele näher erläutert.

### Beispiel 1:

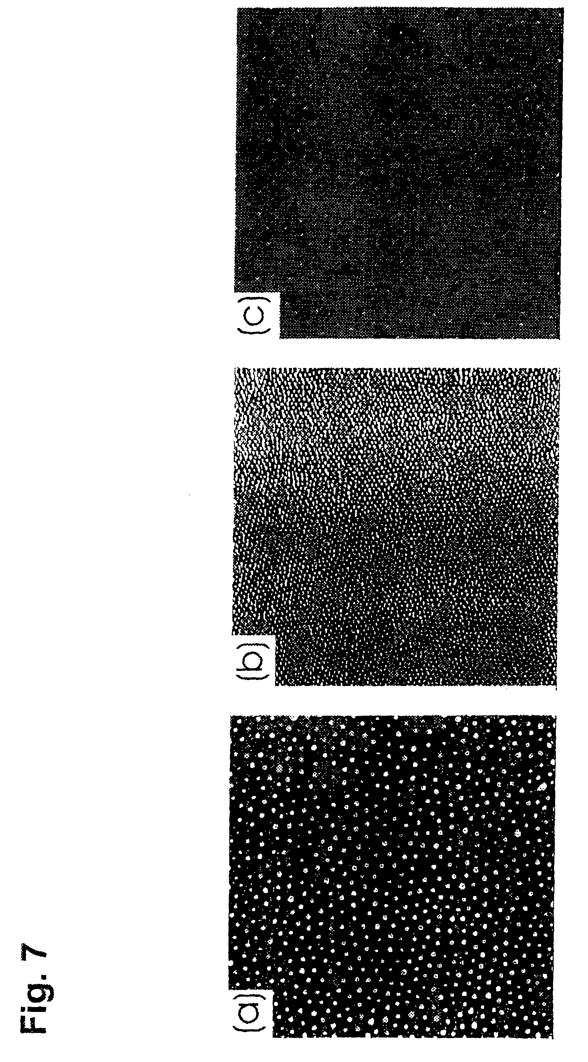

Die Abscheidung von regelmäßig angeordneten Goldcluster auf einem Glimmersubstrat über makroskopische Bereiche mit einem Durchmesser von 12 nm, 3 nm oder 1 nm mit einer Periodizität von 80 nm, 25 bzw. 140 nm nach dem erfindungsgemäßen Verfahren gelingt jeweils mit einer 5mg/ml Poly[styrol]₈₀₀-b-Poly[(2-vinylpyridin)HAuCl₄)_{0,5}]₈₆₀ -Toluollösung, einer 5mg/ml Poly[styrol]₃₂₅-b-Poly[(2-vinylpyridin)(HAuCl₄)_{0,5}]₇₅ -Toluollösung bzw. einer 5mg/ml Poly[styrol]₁₇₀₀-b-Poly[(2-vinylpyridin)(HAuCl₄)_{0,1}]₄₅₀ -Toluollösung durch Ziehen eines frisch gespaltenen Glimmersubstrats mit einer Ziehgeschwindigkeit von 13 mm/min und anschließender Behandlung in einem Sauerstoffplasma bei 200 W für 20 min. Fig. 7 zeigt rasterkraftmikroskopische Aufnahmen der erfindungsgemäßen, im Nanometerbereich oberflächendekorierten Substrate.

### Beispiel 2:

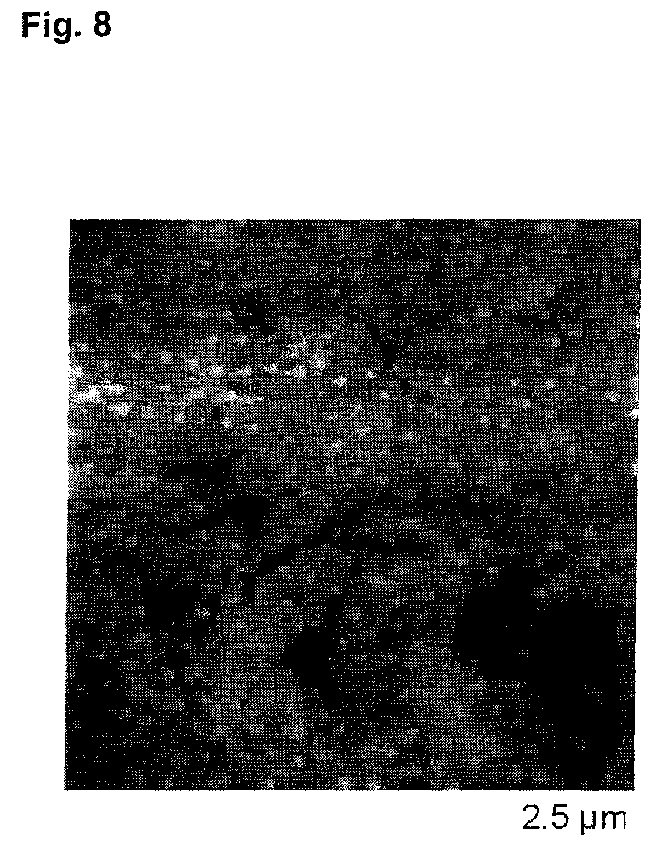

Die Abscheidung von regelmäßig angeordneten Goldcluster auf einem Si-Substrat mit thermisch gewachsenem Oxid oder dünnem natürlichem Oxid über makroskopische Bereiche mit einem Durchmesser von 3 nm mit einer Periodizität von 120 nm nach dem erfindungsgemäßen Verfahren gelingt mit einer 5 mg/ml Poly[styrol]₁₇₀₀-b-Poly[(2-vinylpyridin)(HAuCl₄)_{0,25}]₄₅₀-Toluollösung durch Ziehen eines Si-Wafers mit einer Ziehgeschwindigkeit von 12 mm/min (Si-Wafer mit thermischen Oxid) bzw. 6 mm/min (Si-Wafer mit dünnem Oxidüberzug) und anschließender Behandlung in einem Sauerstoffplasma bei 200 W für 20 min. Fig. 8 zeigt eine rasterkraftmikroskopische Aufnahme des erfindungsgemäßen, im Nanometerbereich oberflächendekorierten Substrats.

### Beispiel 3:

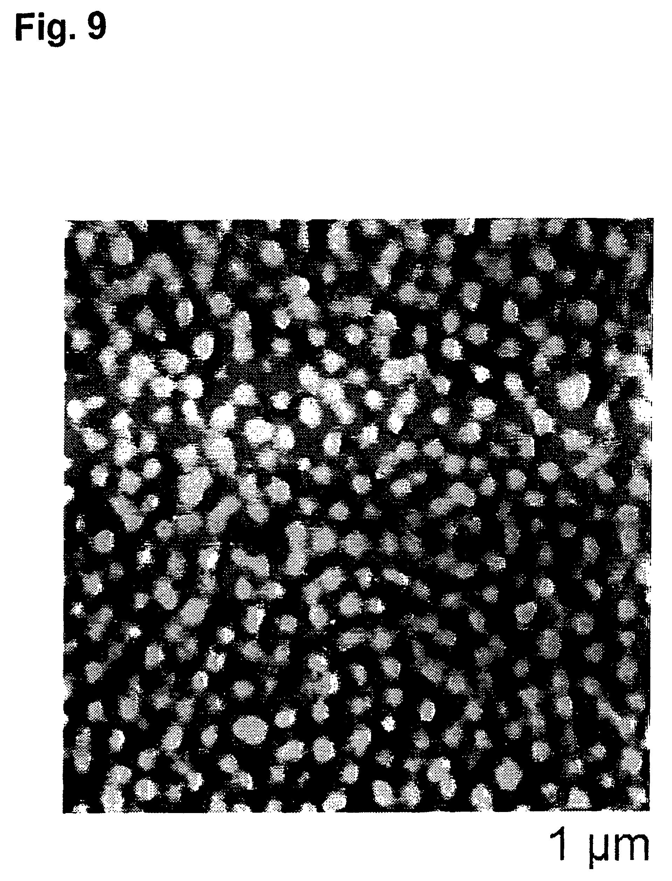

Die Abscheidung von regelmäßig angeordneten Goldcluster auf einem GaAs Substrat über makroskopische Bereiche mit einem Durchmesser von 3 nm mit einer Periodizität von 70 nm nach dem erfindungsgemäßen Verfahren gelingt mit einer 5 mg/ml Poly[styrol]₁₇₀₀-b-Poly[(2-vinylpyridin)(HAuCl₄)_{0,3}]₄₅₀-Toluollösung durch Ziehen eines frisch gespaltenen Glimmersubstrats mit einer Ziehgeschwindigkeit von 18 mm/min und anschließender Behandlung in einem Sauerstoffplasma bei 200 W für 20 min. Fig. 9 zeigt eine rasterkraftmikroskopische Aufnahme des erfindungsgemäßen, im Nanometerbereich oberflächendekorierten Substrates.

### Beispiel 4:

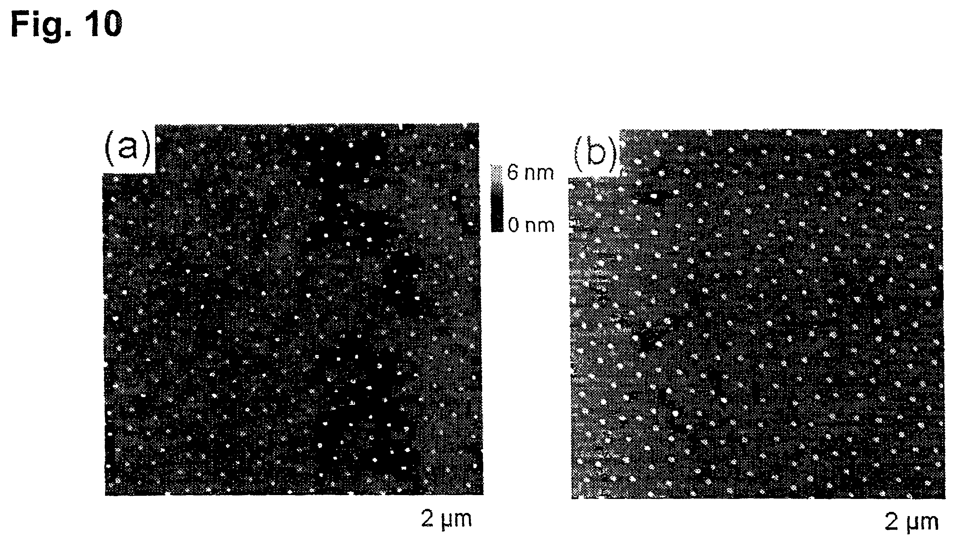

Die Abscheidung von regelmäßig angeordneten Goldcluster auf einem SrTiO₃ Substrat über makroskopische Bereiche mit einem Durchmesser von 3 nm mit einer Periodizität von 120 nm nach dem erfindungsgemäßen Verfahren gelingt mit einer 5 mg/ml Poly[styrol]₁₇₀₀-b-Poly[(2-vinylpyridin)(HAuCl₄)_{0,3}]₄₅₀ -Toluollösung durch Ziehen eines SrTiO₃ Einkristall-Substrats (100) mit einer Ziehgeschwindigkeit von 4 mm/min und anschließender Behandlung in einem Sauerstoffplasma bei 200 W für 20 min. Anschließendes Tempern in einer Argon/Sauerstoffatmosphäre bei 800°C für die Dauer von 15 Minuten zeigte, daß die Anordnung unter diesen Bedingungen stabil bleibt. Fig. 10 zeigt rasterkraftmikroskopische Aufnahmen des erfindungsgemäßen, im Nanometerbereich oberflächendekorierten Substrats vor und nach dem Tempern.

### Beispiel 5:

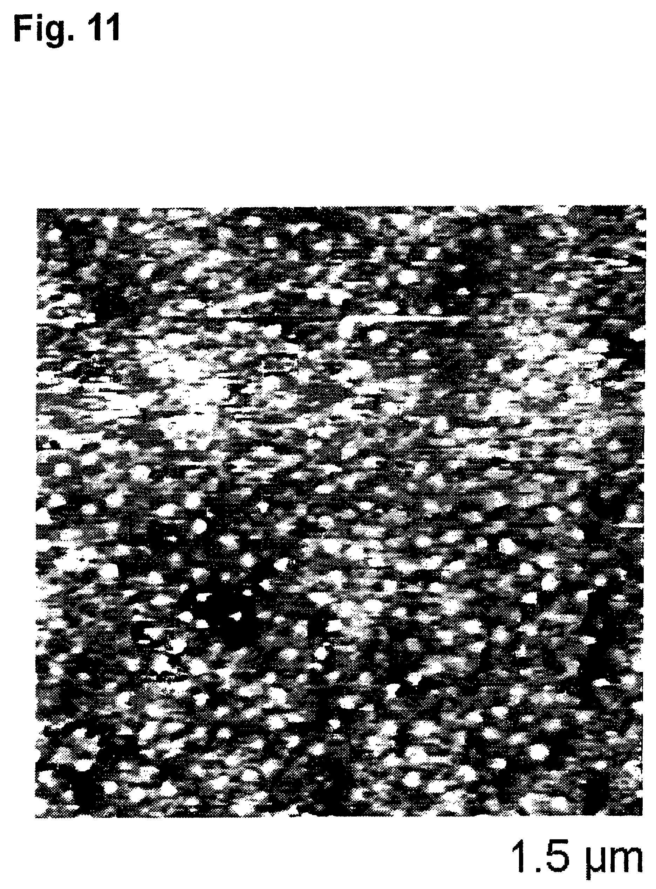

Die Abscheidung von regelmäßig angeordneten Goldcluster auf einem Diamant Substrat über makroskopische Bereiche mit einem Durchmesser von 3 nm mit einer Periodizität von 120 nm nach dem erfindungsgemäßen Verfahren gelingt mit einer 5 mg/ml Poly[styrol]₁₇₀₀-b-Poly[(2-vinylpyridin)(HAuCl₄)_{0,3}]₄₅₀ -Toluollösung durch Ziehen eines frisch gespaltenen Glimmersubstrats mit einer Ziehgeschwindigkeit von 4 mm/min und anschließender Behandlung in einem Sauerstoffplasma bei 150 W für 10 min. Fig. 11 zeigt eine rasterkraftmikroskopische Aufnahme des erfindungsgemäßen, im Nanometerbereich oberflächendekorierten Substrats.

### Beispiel 6:

In einem Minireaktor wurde die Epoxidierung von 1-Octen untersucht. Als Katalysator wurden auf Glimmerplättchen Goldchlorid/Titantetrachlorid-gefüllte Blockcopolymermizellen abgeschieden. Die Beschichtung der 10 bis 50 µm großen Plättchen erfolgte mit einer Lösung von 5 mg/ml Poly[styrol]₃₀₀-b-Poly[(2-vinylpyridin)(HAuCl₄)_{0,1}(TiCl₄)_{0,8}]₃₀₀ in Toluol. Die Plättchen wurden auf einem Cellulosevlies getrocknet. Anschließend wurde das Polymer in einem Röhrenofen in Sauerstoffatmosphäre (T=200°C, p(O₂)=0,5 bar, t = 120 min) abgebaut, wobei die Metallkomponenten in Form kleiner Mischcluster auf dem Glimmer abgeschieden wurden. Die Plättchen wurden in Octan aufgeschlämmt und nach Zugabe von Octen wurde molekularer Sauerstoff direkt in die Lösung eingeblasen. Bei einer Temperatur von 110°C wurde 1-Octenoxid mit 38% Ausbeute gebildet.

### Beispiel 7:

Die Oxidationskatalyse von CO zu CO₂ wurde mit auf Glimmerplättchen aufgebrachten Goldchlorid/Eisentrichlorid-haltigen Blockcopolymermizellen untersucht. Die Beschichtung der 10 bis 50 µm großen Plättchen erfolgte mit einer Lösung von 5 mg/ml Poly[styrol]₃₀₀-b-Poly[(2-vinylpyridin)(HAuCl₄)_{0,1}(FeCl₃)_{0,5}]₃₀₀ in Toluol. Die Plättchen wurden auf einem Cellulosevlies getrocknet. Anschließend wurde das Polymer, wie in Beispiel 6 beschrieben, in einem Röhrenofen in Sauerstoffatmosphäre (T = 200°C, p(O₂) = 0,5 bar, t = 120 min) abgebaut. Der Katalysator wurde in ein temperierbares Glasrohr eingeschlossen und das Reaktionsgas (1% CO, 1% O₂, 75% H₂, 23% N₂) daran vorbeigeleitet. Die Umsetzung von CO zu CO₂ wurde gaschromatographisch detektiert. Bei 80°C wurde unter diesen Bedingungen das CO zur Hälfte umgesetzt.

### Beispiel 8:

Monomizellare Filme, bestehend aus (a) Poly[styrol]₆₄₀-b-Poly[ethylen-oxid)(LiAu-Cl₄)_{0,3}]₂₂₀-Mizellen, wobei die Au³⁺-Ionen durch Elektronenstrahlung im Film reduziert wurden und somit die Abscheidung von vielen Au-Krjstalliten in einer Mizelle bewirkt wurde, und (b) Poly[styrol]₃₀₀-b-Poly[(2-vinylpyridin)(HAuCl₄)_{0,5}]₃₀₀, wobei das Au³⁺-Ion in Lösung zu Au umgewandelt und das Wachstum von einem, im Durchmesser ca. 6 nm großen Kristall in jeder einzelnen Mizelle vor der Filmbildung induziert wurde, wurden durch Ziehen eines mit Kohlenstoff beschichteten Cu-Netzes aus jeweils einer 5 mg/ml konzentrierten Toluollösung und einer Ziehgeschwindigkeit von 7 mm/min hergestellt. Fig. 12 zeigt transmissionselektronenmikroskopische Aufnahmen (TEM) davon sowie die schematischen Darstellungen der jeweiligen Filme.

### Beispiel 9:

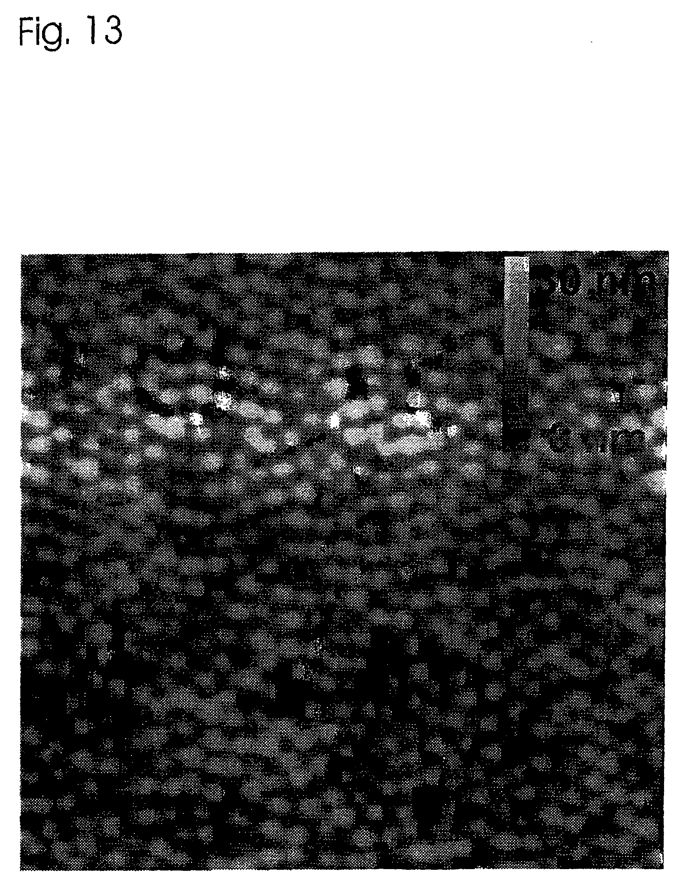

Ein monomizellarer Polymerfilm von Poly[styrol]₁₇₀₀-b-Poly[(2-vinylpyridin)(HAuCl₄)_{0,4}]₄₅₀-Mizellen auf einem Si-Wafer wurde durch Ziehen des Substrates aus einer 5 mg/ml konzentrierten Toluollösung mit einer Ziehgeschwindigkeit von 10 mm/min gewonnen. Fig. 13 zeigt eine kraftmikroskopische Aufnahme davon.

### Beispiel 10:

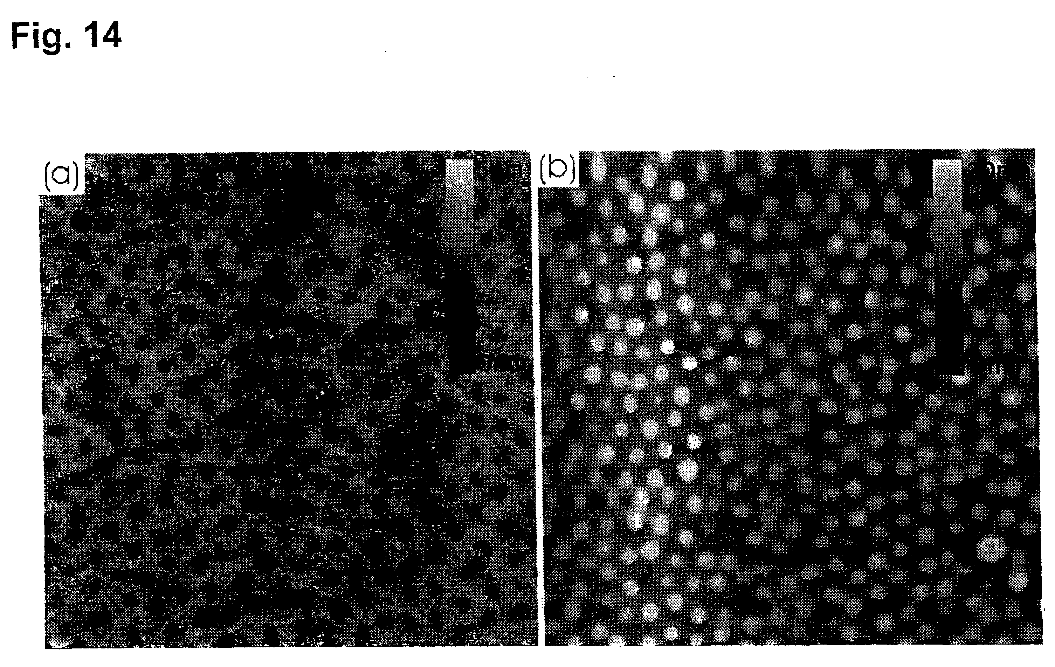

Ein monomizellarer Polymerfilm, bestehend aus Poly[styrol]₁₇₀₀-b-Poly[(2-vinylpyridin)]₄₅₀-Mizellen auf einem GaAs-Wafer, wurde mit Ar-Ionen (1,1 keV, 12 µA/cm²) für 15 min geätzt, wobei im Falle der Löcher jede Mizelle mit einem ⌀ = 10 nm Au-Teilchen beladen und im Falle der Inseln 4 von 10 der 2-Vinylpyridin-Einheiten mit einem HAuCl₄ in Lösung neutralisiert war Fig. 14 zeigt eine kraftmikroskopischen Aufnahmen derart strukturierter GaAs-Wafer.

### Beispiel 11:

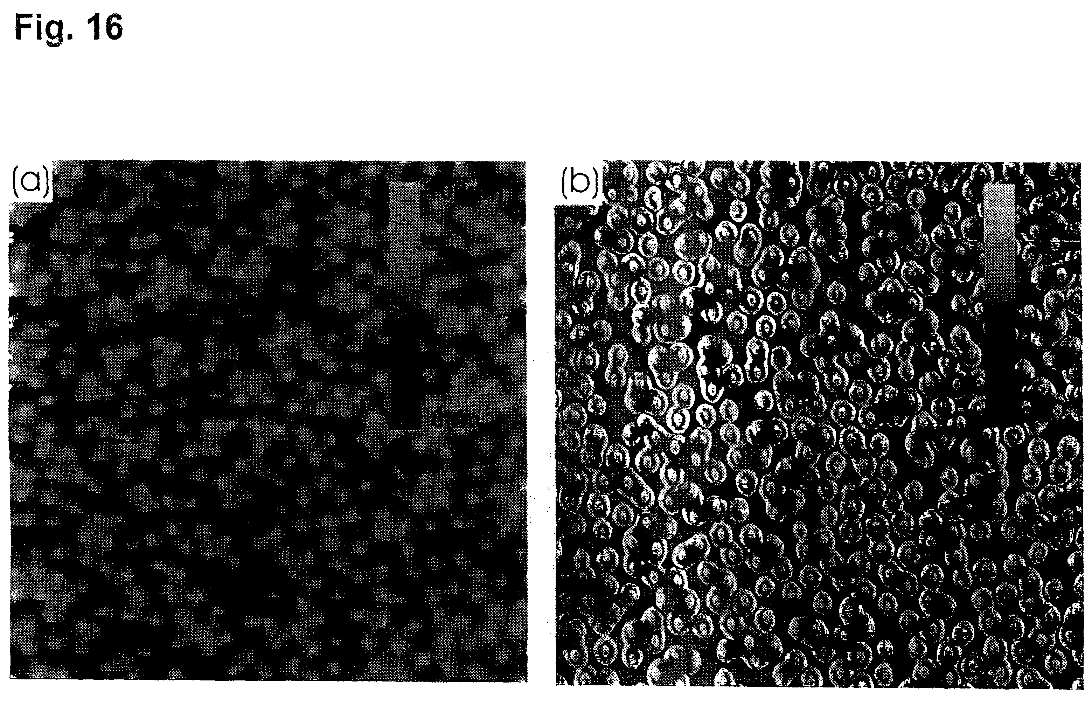

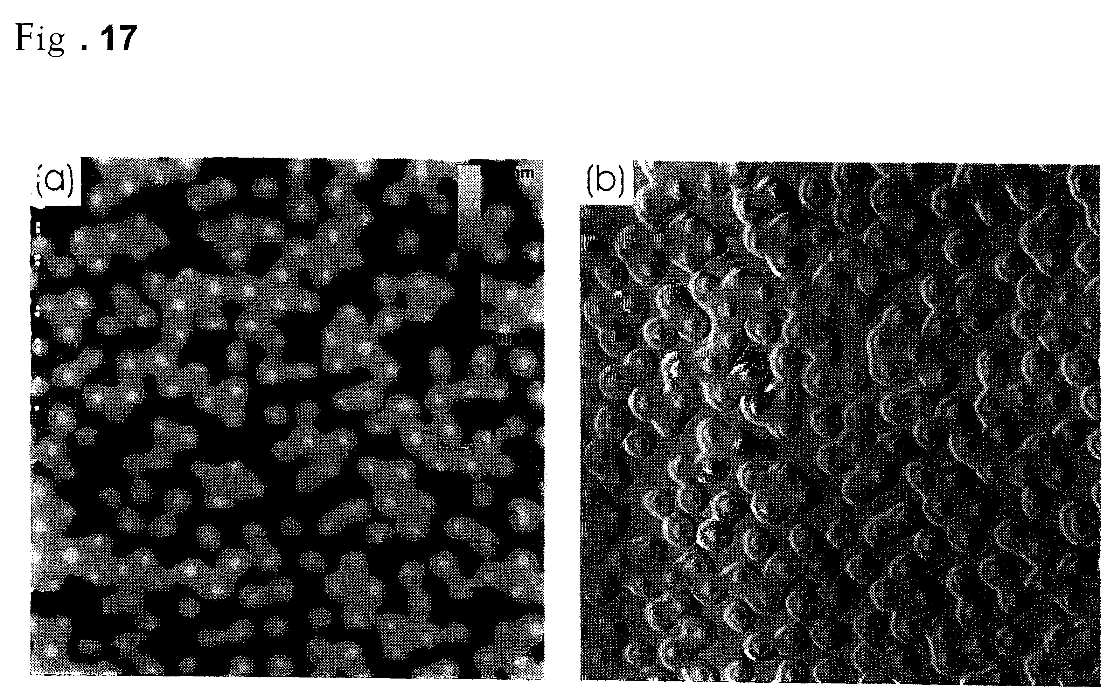

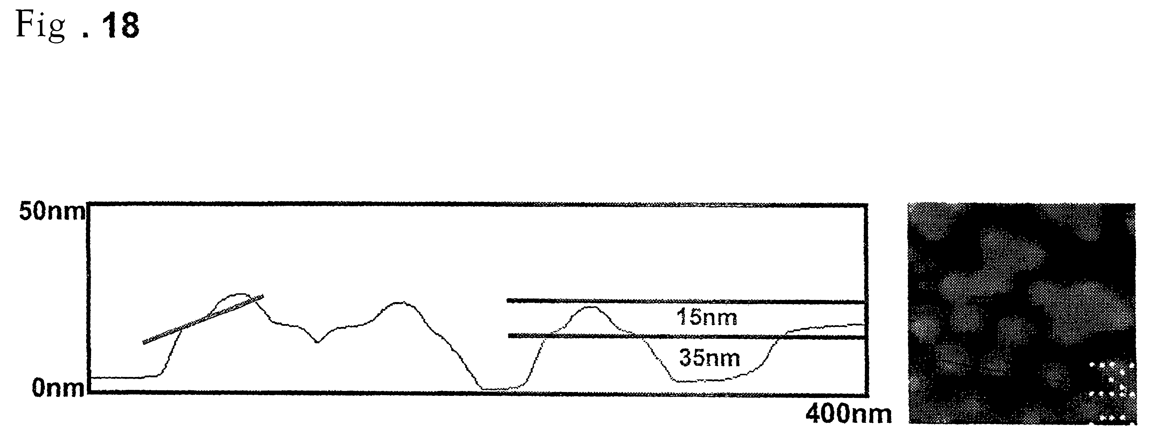

Ein mizellarer Film, bestehend aus Poly[styrol]₁₇₀₀-b-Poly[(2-vinylpyridin)(HAuCl₄)_{0,4}]₄₅₀-Mizellen, wurde durch Ziehen eines GaAs-Substrats mit einer Geschwindigkeit von 2 mm/min aus einer 5 mg/ml konzentrierten Lösung abgeschieden. Der nicht deckende mizellare Film als Ätzmaske wurde 15 min durch Ar-Ionen (1,1 keV, 12µA/cm²) geätzt. Fig. 16b zeigt keinen relativen Kontrast des Reibungskoeffizienten an der Oberfläche. Nur GaAs konnte nach dem Ätzprozeß bestimmt werden. Figur 17 zeigt einen anderen Ausschnitt des gleichen Films und Figur 17b die senkrecht zur Oberfläche auftretenden Deflektion der rasterkraftmikroskopischen Nadel. Das entstehende zweistufige GaAs-Relief ist in Figur 18 im Profil gezeigt.

### Beispiel 12:

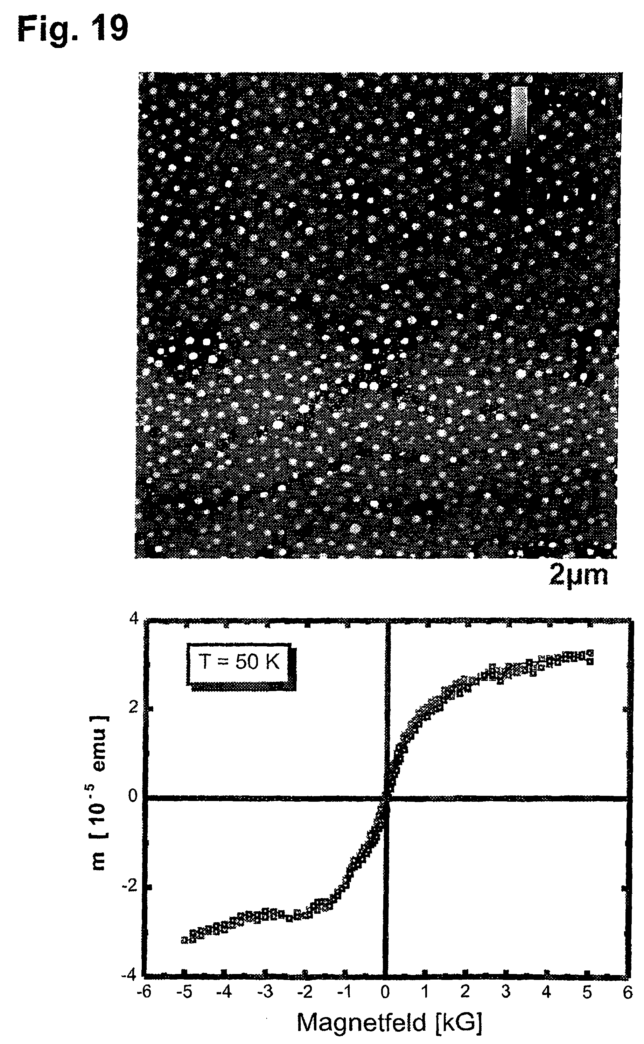

Die Abscheidung von regelmäßig angeordneten Cobaltcluster auf einem Silicium-Substrat mit thermisch gewachsenem Oxid oder dünnem natürlichen Oxid über makroskopische Bereiche mit einem Durchmesser von 12 nm und einer Periodizität von 80 nm nach dem erfindungsgemäßen Verfahren gelingt mit einer 5 mg/ml Poly[styrol]₈₀₀-b-Poly[(2-vinylpyridin)(CoCl₂)_{0,4}]₈₆₀ -Toluollösung durch Ziehen eines Si-Wafers mit einer Ziehgeschwindigkeit von 13 mm/min (Si-Wafer mit thermischem Oxid) bzw. 6 mm/min (Si-Wafer mit dünnem Oxidüberzug) und anschließender Behandlung in einem Wasserstoffplasma bei 70 W für 15 min. Fig. 19 zeigt eine rasterkraftmikroskopische Aufnahme des erfindungsgemäßen, im Nanometerbereich oberflächendekorierten Substrats und die zugehörige Magnetisierungskurve bei T = 50 K. Das Nichtvorhandensein einer Hysterese deutet auf superferromagnetische Eigenschaften der Cobaltcluster hin.

### Beispiel 13:

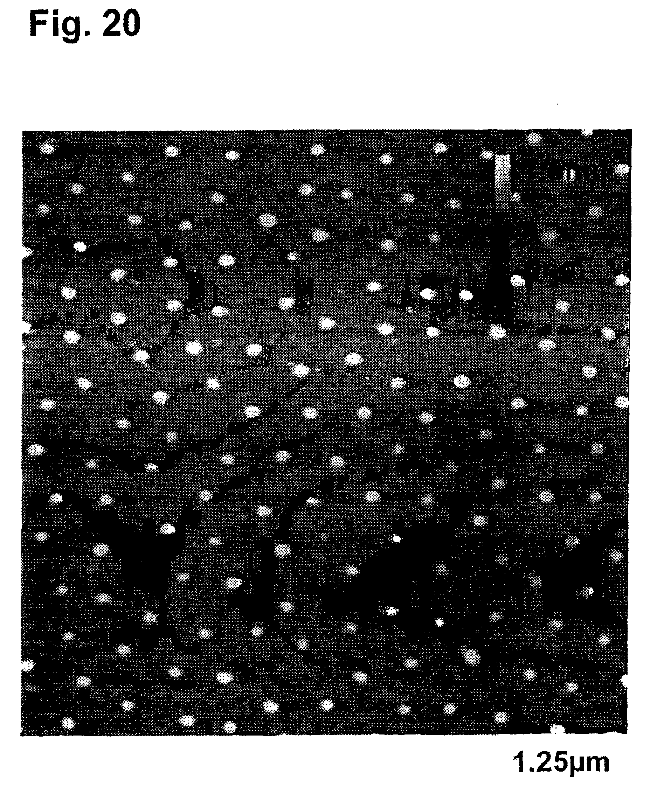

Die Abscheidung von regelmäßig angeordneten Nickelcluster auf einem Glimmersubstrat über makroskopische Bereiche mit einem Durchmesser von 6 nm und einer Periodizität von 140 nm nach dem erfindungsgemäßen Verfahren gelingt mit einer 5 mg/ml Poly[styrol]₁₇₀₀-b-Poly[(2-vinylpyridin)(NiCl₂)_{0,5}]₄₅₀ - Toluollösung durch Ziehen eines frisch gespaltenen Glimmersubstrats mit einer Ziehgeschwindigkeit von 12 mm/min und anschließender Behandlung in einem Wasserstoffplasma bei 70 W für 5 min. Fig. 20 zeigt eine rasterkraftmikroskopische Aufnahme des erfindungsgemäßen, im Nanometerbereich oberflächendekorierten Substrats.

### Beispiel 14:

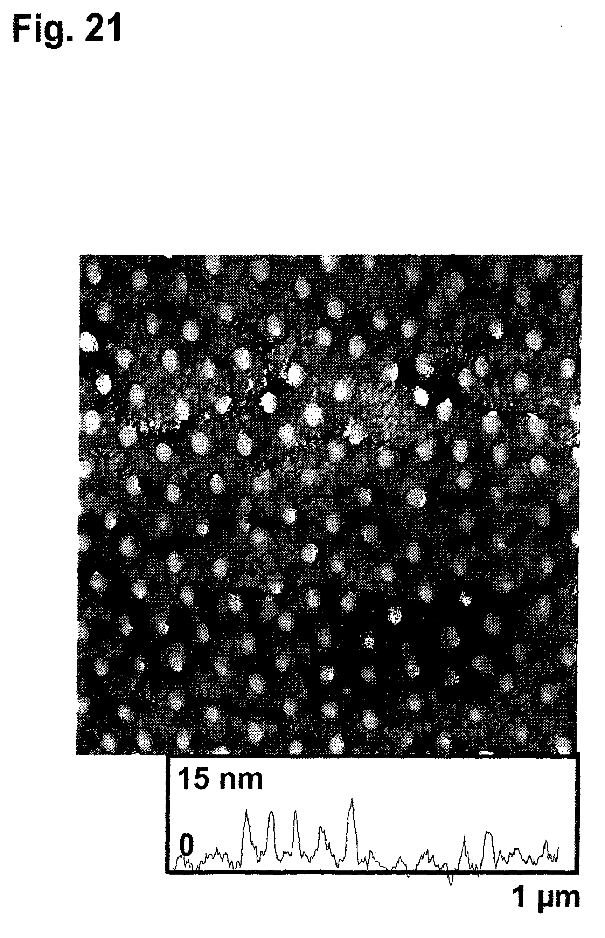

Die Abscheidung von regelmäßig angeordneten Goldcluster auf einem Silicium-Substrat mit thermisch gewachsenem Oxid oder dünnem natürlichen Oxid über makroskopische Bereiche mit einem Durchmesser von 8 nm und einer Periodizität von 100 nm nach dem erfindungsgemäßen Verfahren gelingt mit einer 5 mg/ml Poly[styrol]₁₇₀₀-b-Poly[(2-vinylpyridin)(HAuCl₄)_{0,5}]₄₅₀ -Toluollösung durch Ziehen eines Si-Wafers mit einer Ziehgeschwindigkeit von 15 mm/min (Si-Wafer mit thermischem Oxid) bzw. 10 mm/min (Si-Wafer mit dünnem Oxidüberzug) und anschließender Behandlung in einem Tetrafluormethanplasma bei 100 W für 10 min. Fig. 21 zeigt eine rasterkraftmikroskopische Aufnahme des erfindungsgemäßen, im Nanometerbereich oberflächendekorierten Substrats.

### Beispiel 15:

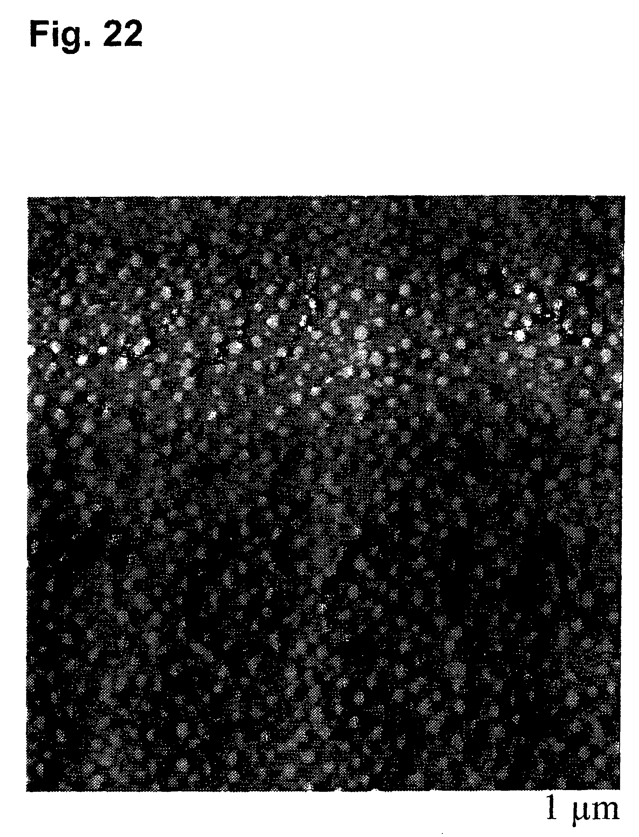

Die Abscheidung von regelmäßig angeordneten Platincluster auf einem Goldsubstrat über makroskopische Bereiche mit einem Durchmesser von 4 nm und einer Periodizität von 40 nm nach dem erfindungsgemäßen Verfahren gelingt mit einer 5 mg/ml Poly[styrol]₁₉₀-b-Poly[(2-vinylpyridin)(K[PtCl₃C₂H₄])_{0,4}]₁₉₀ - Toluollösung durch Ziehen eines Goldeinkristall-Substrats (100) mit einer Ziehgeschwindigkeit von 12 mm/min und anschließender Behandlung in einem Sauerstoffplasma bei 120 W für 10 min. Fig. 22 zeigt eine rasterkraftmikroskopische Aufnahme des erfindungsgemäßen, im Nanometerbereich oberflächendekorierten Substrats.

### Beispiel 16:

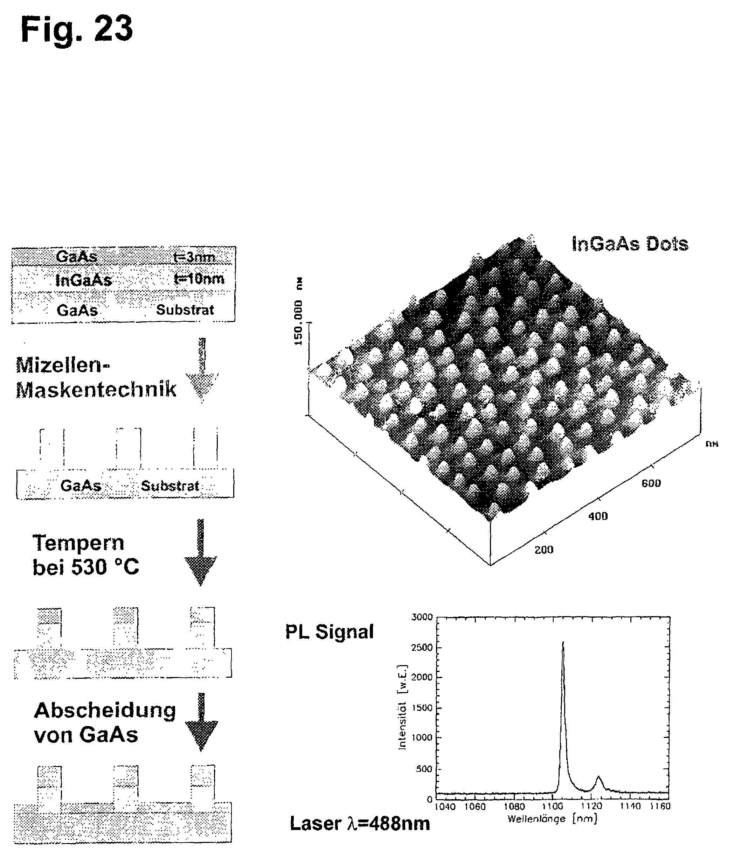

Ein monomizellarer Polymerfilm, bestehend aus Poly[styrol]₁₇₀₀-b-Poly[(2-vinylpyridin) (HAuCl₄)_{0,4}]₄₅₀-Mizellen, wurde durch Ziehen eines Halbleiterschichtsubstrats [GaAs (3 nm); InGaAs (10 nm); GaAs (Substrat)] mit einer Geschwindigkeit von 10 mm/min aus einer 5 mg/ml konzentrierten Lösung abgeschieden. Der mizellare Film als Ätzmaske wurde 15 min durch Ar⁺-Ionen (1,1 keV, 12 µA/cm²) geätzt. Fig. 23 zeigt eine dreidimensionale Struktur der erhaltenen "Quanten-Dots". Daß es sich bei den in Fig. 23 gezeigten Inseln um "Quantenpunkte" handelt, wurde durch Photolumineszenzmessungen bestätigt.

## Patentansprüche

1. Verfahren zur Herstellung von im Nanometerbereich oberflächendekorierten Substraten, umfassend die Schritte:
(a) Aufnehmen eines Polymers in einem geeigneten Lösungsmittel unter Bildung eines gelösten Kern-Schale-Polymersystems,
(b) Beladen von mindestens einem Teil der Polymerkerne mit einer oder mehreren, gleichen oder unterschiedlichen Metallverbindungen,
(c) Aufbringen des in Schritt (b) erhaltenen, beladenen Kern-Schale-Polymersystems als Film derart auf mindestens eine Seite eines Substrats, daß das Kern-Schale-Polymersystem in einer regelmäßigen Struktur im Film angeordnet ist, und
(d) Entfernen des das Kern-Schale-Polymersystem aufbauenden Polymers unter Erzeugung von Metallclustern und/oder Clustern von Metallverbindungen auf der Substratoberfläche ohne wesentliche Änderung der durch das Kern-Schale-Polymersystem aufgebauten Struktur.

2. Verfahren nach Anspruch 1, wobei vor Schritt (c) die im Kern-Schale-Polymersystem enthaltene(n) Metallverbindung(en) durch chemische Behandlung und/oder durch energiereiche Strahlung in Lösung oder im Film in das Metall oder ein Metalloxid überführt wird bzw. werden.

3. Verfahren nach Anspruch 1 oder 2, wobei im Schritt (d) das Polymer mittels eines Ätz-, Reduktions- oder Oxidationsprozesses entfernt wird.

4. Verfahren nach Anspruch 3, wobei das Polymer mittels eines Sauerstoffplasmas entfernt wird.

5. Verfahren zur Herstellung von im Nanometerbereich oberflächenstrukturierten Substraten, umfassend die Schritte:
(a) Aufnehmen eines Polymers in einem geeigneten Lösungsmittel unter Bildung eines gelösten Kern-Schale-Polymersystems,
(b) Beladen von mindestens einem Teil der Polymerkerne mit einer oder mehreren, gleichen oder unterschiedlichen Metallverbindungen,
(c) Aufbringen des in Schritt (b) erhaltenen Kern-Schale-Polymersystems als Film derart auf mindestens eine Seite eines Substrats, daß das Kern-Schale-Polymersystem in einer regelmäßigen Struktur im Film angeordnet ist, und
(d) Unterwerfen des in Schritt (c) erhaltenen Substrats einem reaktiven lonenätzverfahren, einem lonensputterverfahren oder einem naßchemischen Verfahren oder einer Kombination davon, wobei der auf dem Substrat aufgebrachte Film entfernt wird, und worin die durch das Kern-Schale-Polymersystem erzeugte, regelmäßige Struktur aufgrund und in Abhängigkeit von der Art der Beladung der Mizellkerne sowie der Dauer des reaktiven lonenätzverfahrens und/oder des lonensputterverfahrens und/oder des naßchemischen Verfahrens in eine Reliefstruktur des Substrats überführt wird.

6. Verfahren nach Anspruch 5, wobei vor dem Aufbringen als Film oder nach der Filmbildung mindestens ein Teil der in den Polymerkernen enthaltenen Metallverbindungen durch chemische Behandlung und/oder energiereiche Strahlung zu einem oder mehreren Metall- und/oder Metalloxidteilchen in jedem einzelnen Polymerkern überführt wird.

7. Verfahren nach Anspruch 5 oder 6, wobei mindestens ein Teil der in den Polymerkernen enthaltenen Metallverbindungen in Lösung durch einen Reduktions- oder Oxidationsprozeß zu einem oder mehreren Metall- und/oder Metalloxidteilchen in jedem einzelnen Polymerkern derart überführt wird, daß ein Teil der beladenen Polymerkerne ein oder mehrere Metallatome und/oder ein oder mehrere Metallverbindungen enthält.

8. Verfahren nach Anspruch 7, worin die Reduktion in Lösung mittels Hydrazin durchgeführt wird.

9. Verfahren nach einem der Ansprüche 5 bis 8, wobei in Schritt (d) ein Argonionen-Sputterverfahren durchgeführt wird.

10. Verfahren nach einem der Ansprüche 1 bis 9, wobei das Polymer aus Blockcopolymeren, Pfropfcopolymeren, Miktoarmsternpolymeren, Sternpolymeren mit unterschiedlichen Armen, dentritischen Polymeren, Mikrogelteilchen, Sternblockpolymeren, Blocksternpolymeren und Kern-Schale-Latexpolymeren ausgewählt ist.

11. Verfahren nach Anspruch 10, wobei das Polymer Polystyrol-b-polyethylenoxid, Polystyrol-b-poly(2-vinylpyridin), Polystyrol-b-poly(4-vinylpyridin) oder ein Gemisch davon ist.

12. Verfahren nach einem der Ansprüche 1 bis 1 1, wobei die Metallverbindung aus Verbindungen von Au, Pt, Pd, Ag, In, Fe, Zr, Al, Co, Ni, Ga, Sn, Zn, Ti, Si und Ge in den entsprechenden Oxidationsstufen oder Gemischen davon ausgewählt ist.

13. Verfahren nach Anspruch 12, wobei die Metallverbindung aus HAuCl₄, MeAuCl₄, wobei Me ein Alkalimetall bedeutet, H₂PtCl₆, Pd(Ac)₂, Ag(Ac), AgNO₃, InCl₃, FeCl₃, Ti(OR)₄, TiCl₄, TiCl₃, CoCl₃, NiCl₂, SiCl₄, GeCl₄, GaH₃, ZnEt₂, Al(OR)₃, Zr(OR)₄, Si(OR)₄, wobei R einen geradkettigen oder verzweigten C₁-C₈-Alkylrest bedeutet, Ferrocen, Zeisesalz und SnBu₃H oder Gemischen davon ausgewählt ist.

14. Verfahren nach Anspruch 13, wobei die Metallverbindung HAuCl₄ ist.

15. Verfahren nach einem der Ansprüche 1 bis 14, wobei das Substrat aus Edelmetallen, oxidischen Gläsern, mono- oder multikristallinen Substraten, Halbleitern, Metallen mit oder ohne passivierter Oberfläche oder Isolatoren ausgewählt ist.

16. Verfahren nach Anspruch 15, wobei das Substrat aus Si, SiO₂, Pt, Au, GaAs, In_{y}GaAs, AlₓGaAs, Ge, SiₓN_{y}, SiₓGaAs, InP, InPSi, GalnAsP, Glas, Graphit, Diamant, Glimmer, SrTiO₃ oder deren dotierte Modifikationen ausgewählt ist.

17. Verfahren nach einem der vorhergehenden Ansprüche, worin in Schritt (c) das Aufbringen des Films in Mono- oder Multischichten durch Tauch-, Gieß-, Spinschleuderverfahren oder durch Adsorption aus verdünnter Lösung durchgeführt wird.

18. Verfahren nach Anspruch 17, worin das Aufbringen in Mono- oder Multischichten durch Tauchverfahren aus verdünnter Lösung durchgeführt wird.

19. Verfahren nach Anspruch 17 oder 18, wobei der in Schritt (c) erhaltene Film eine Schichtdicke von 5 bis 800 nm aufweist.

20. im Nanometerbereich oberflächendekoriertes Substrat, welches auf der Oberfläche Cluster von Metallatomen und/oder Metallverbindungen umfaßt, wobei die Cluster regelmäßig auf der Substratoberfläche angeordnet sind.

21. Substrat nach Anspruch 20, wobei die Cluster einen Durchmesser von 0,5 bis 100 nm aufweisen.

22. Substrat nach Anspruch 20 oder 21, wobei die Cluster mit einem Abstand von bis zu 400 nm regelmäßig auf der Substratoberfläche angeordnet sind.

23. Substrat nach einem der Ansprüche 20 bis 22, wobei die Cluster aus gleichen oder unterschiedlichen Metallatomen und/oder Metalloxiden bestehen.

24. Substrat nach Anspruch 23, wobei die Cluster aus Goldatomen bestehen.

25. Substrat nach Anspruch 23, wobei die Cluster aus Au/Fe₂O₃, Au/CoO, Au/Co₃O₄, Au/ZnO, Au/TiO₂, Au/ZrO₂, Au/Al₂O₃, Au/In₂O₃, Pd/Al₂O₃, Pd/ZrO₂, Pt/Graphit oder Pt/Al₂O₃ bestehen.

26. Substrat nach einem der Ansprüche 20 bis 25, wobei das Substrat aus Pt, Au, GaAs, In_{y}GaAs, AlₓGaAs, Si, SiO₂, Ge, SiₓN_{y}, SiₓGaAs, InP, InPSi, GaInAsP, Glas, Graphit, Diamant, Glimmer, SrTiO₃ oder deren dotierte Modifikationen ausgewählt ist.

27. Verwendung des im Nanometerbereich oberflächendekorierten Substrats nach einem der Ansprüche 20 bis 26 zur Epoxidierung von C₃-C₈-Alkenen oder zur Oxidation von CO zu CO₂.

28. Oberflächenstrukturiertes Substrat, erhältlich nach einem Verfahren gemäß einem der Ansprüche 5 bis 19.

29. Oberflächenstrukturiertes Substrat, welches eine Reliefstruktur mit lateralen Dimensionen zwischen 1 und 100 nm über makroskopische Bereiche aufweist.

30. Substrat nach Anspruch 29, welches aus Edelmetallen, oxidischen Gläsern, mono- oder multikristallinen Substraten, Halbleitern, Metallen mit oder ohne passivierter Oberfläche oder Isolatoren ausgewählt ist.

31. Substrat nach Anspruch 30, welches aus Pt, Au, GaAs, In_{y}GaAs, AlₓGaAs, Si, SiO₂, Ge, SiₓN_{y}, SiₓGaAs, InP, InPSi, GalnAsP, Glas, Graphit, Diamant, Glimmer, SrTiO₃ oder deren dotierte Modifikationen ausgewählt ist.

## Claims

1. A method for manufacturing nanometrically surface-decorated substrates, comprising the stages:
(a) introducing a polymer into an appropriate solvent while forming a dissolved core-shell polymer system,
(b) charging at least some of the polymer cores with one or more identical or different metal compounds,
(c) depositing the core-shell polymer system prepared as a film in stage (b) in such manner on at least one side of a substrate that the core-shell polymer system is configured in a regular structure, and
(d) removing the polymer erecting the core-shell polymer system while producing metal clusters and/or metal-compound clusters on the substrate surface without thereby significantly modifying the structure erected by the core-shell polymer system.

2. Method as claimed in claim 1, where the metal compound(s) contained in the core-shell polymer system is (are) converted chemically and/or by high-energy irradiation in solution or in the film into the metal or a metal oxide prior to stage (c).

3. Method as claimed in either of claims 1 and 2, wherein the polymer is removed in stage (d) by etching, reduction or oxidation.

4. Method as claimed in claim 3, wherein the polymer is removed using oxygen plasma.

5. A method for manufacturingnanometric surface-structured substrates, including the stages:
(a) introducing a polymer into an appropriate solvent while forming a dissolved core-shell polymer system,
(b) charging at least some of the polymer cores with one or more identical or different metal compounds,
(c) depositing the core-shell polymer system prepared in stage (b) in the form of a film on at least one side of substrate in such manner that the core-shell polymer system is configured in a regular structure in the film, and
(d) subjecting the substrate prepared in stage (c) to reactive ion etching, ion sputtering or a wet-chemical procedure or a combination thereof, whereby the film deposited on the substrate shall be removed and the regular structure generated by the core-shell polymer system is converted into a substrate relief topography by means of and depending on the kind of charge on the micelle cores and the duration of etching and/or ion sputtering and/or the wet-chemical procedure.

6. Method as claimed in claim 5, wherein at least some of the metal compounds contained in the polymer cores will be converted by chemical treatment and/or by high-energy irradiation before deposition as a film or after film formation into one or more metal particle(s) and/or metal-oxide particle(s) in each individual polymer core.

7. Method as claimed in either of claims 5 and 6, wherein at least some-of the metal compounds contained in the polymer cores are converted in such manner in solution by reduction or oxidation into one or more metal particle(s) and/or metal-oxide particle(s) in each individual polymer core, that some of the charged polymer cores contain one or more metal atoms and/or one or more metal compounds.

8. Method as claimed in claim 7, wherein the reduction in solution is carried out using hydrazine.

9. Method as claimed in one of claims 5 through 8, wherein argon ion sputtering is carried out in stage (d).

10. Method as claimed in one of claims 1 through 9, **characterized in that** the polymer is selected from block copolymers, graft copolymers, micto-branch polymers, star polymers having different branches, dendritic polymers, microgel particles, star block copolymers, block star polymers and core-shell latex polymers.

11. Method as claimed in claim 10, wherein the polymer is polystyrene-b-polyethyleneoxide, polystyrene-b-poly(2-vinylpyridine), polystyrene-b-poly(4-vinylpyridine) or a mixture thereof.

12. Method as claimed in one claims 1 through 11, wherein the metal compound is selected from compounds of Au, Pt, PdAg, In, Fe, Zr, Al, Co, Ni, Ga, Sn, Zn, Ti, Si and Ge in the corresponding oxidation stages or mixtures thereof.

13. Method as claimed in claim 12, wherein the metal compound is selected from HAuCl₄, MeAuCl₄, where Me denotes alkali metal, H₂PtCl₆, Pd(Ac)₂, Ag(Ac), AgNo₃, InCl₃, FeCl₃ , Ti(OR)₄, TiCl₄, TiCl₃, CoCl₃, NiCl₂, SiCl₄, GeCl₄, GaH₃, ZnEt₂, Al(OR)₄ ,Zr(OR)₃, Si(OR)₄, where R denotes a straight-chain or a branched C₁- C₈ alkyl residue, ferrocene, a Zeisel salt and SnBu₃ H or mixture thereof.

14. Method as claimed in claim 13, wherein the metal compound is HAuCl₄₋.

15. Method as claimed in one of claims 1 through 14, wherein the substrate is selected from the precious metals, oxidic glasses, monocrystalline or multi-crystalline substrates, semiconductors, metals with or without a passivated surface, or insulators.

16. Method as claimed in claim 15, wherein the substrate is selected fromSi, SiO₂, Pt, Au, GaAs, In_{y}GaAs, AlₓGasAs, Ge, SiₓN_{y}, SiₓGaAs, InP, InPSi, GaInAsP, glass, graphite, diamond, mica, SrTiO₃, or their doped modifications.

17. Method as claimed in one of the above claims, wherein the film deposition in single or multiple layers is carried out by dipping, pouring, spin coating or by adsorption in diluted solution.

18. Method as claimed in claim 17, wherein the deposition in single or multiple layers is carried out by dipping in dilute solutions.

19. Method as claimed in either of claims 17 and 18, wherein the film thickness implemented in stage (c) is between 5 and 800 nm.

20. A nanometrically surface-decorated substrate comprising clusters of metal atoms and/or metal compounds at its surface, where the clusters are configured in a regular pattern on the substrate surface.

21. Substrate as claimed in claim 20, where the clusters are of a diameter between 0.5 and 100 nm.

22. Substrate as claimed in either of claims 20 and 21, where the clusters are regularly arrayed on the substrate surface at spacings up to 400 nm.

23. Substrate as claimed in one of claims 20 through 22, where the clusters are composed of identical or different metal atoms and/or metal oxides.

24. Substrate as claimed in claim 23, where the clusters consist of gold atoms.

25. Substrate as claimed in claim 23, where the clusters consist of Au/Fe₂O₃, Au/CoO, Au/Co₃ O₄, Au/ZnO, Au/TiO₂, AuZrO₂, Au/Al₂O₃, Au/In₂O₃, Pd/Al₂O₃ , Pd/ZrO₂, Pt/graphite or Pt/Al₂O₃.

26. Substrate as claimed in one of claims 20 through 25, where the substrate is selected from Pt, Au, GaAs, In_{y}GaAs, Alₓ GaAs, Si, SiO₂, Ge, SiₓN_{y} , SiₓGaAs, InP, InPSi, GaInAsP, glass, graphite, diamond, mica, SrTiO₃, or their doped modifications.

27. Application of the nanometric surface-decorated substrate claimed in one of claims 20 through 26 to the epoxidation of C₃ - C₈alkenes or in the oxidation of CO to CO₂.

28. Surface-structured substrate manufactured in the manner of a method claimed in one of claims 5 through 19.

29. Surface-structured substrate having a relief topography of lateral dimensions between 1 and 100 nm across macroscopic zones.

30. Substrate as claimed in claim 29, selected from precious metals,oxidic glasses, mono-crystalline or multi-crystalline substrates, semiconductors, metals with or without a passivated surface or insulators.

31. Substrate as claimed in claim 30, selected from Pt, Au,GaAs, In_{y}GaAs, AlₓGaAs, Si, SiO₂, Ge, Siₓ N_{y} , SiₓGaAs, InP, InPSi, GaInAsP, glass, graphite, diamond, mica, SrTiO₃ or their doped modifications.

## Revendications

1. Procédé de fabrication de substrats décorés en surface dans le domaine du nanomètre, comprenant les étapes suivantes :
(a) introduction d'un polymère dans un solvant approprié avec formation d'un système de polymère noyau-enveloppe dissous,
(b) chargement d'au moins une partie des noyaux de polymère avec une ou plusieurs combinaisons métalliques identiques ou différentes,
(c) application du système de polymère noyau-enveloppe chargé, obtenu à l'étape (b) sous forme de film, sur au moins un côté d'un substrat, de telle sorte que le système de polymère noyau-enveloppe est disposé dans le film en une structure régulière, et
(d) élimination du polymère formant le système de polymère noyau-enveloppe avec production de groupes constitués de métal et/ou de groupes constitués de combinaisons métalliques sur la surface du substrat sans modification importante de la structure formée par le système de polymère noyau-enveloppe.

2. Procédé selon la revendication 1, dans lequel, avant l'étape (c), la (les) combinaison(s) métallique(s) contenue(s) dans le système de polymère noyau-enveloppe est (sont) convertie(s) en métal ou en oxyde métallique par traitement chimique et/ou par rayonnement riche en énergie en solution ou dans le film.

3. Procédé selon la revendication 1 ou 2, dans lequel, à l'étape (d), le polymère est éliminé au moyen d'un processus d'attaque, de réduction ou d'oxydation.

4. Procédé selon la revendication 3, dans lequel le polymère est éliminé au moyen d'un plasma d'oxygène.

5. Procédé de fabrication de substrats structurés en surface dans le domaine du nanomètre, comprenant les étapes suivantes :
(a) introduction d'un polymère dans un solvant approprié avec formation d'un système de polymère noyau-enveloppe dissous,
(b) chargement d'au moins une partie des noyaux de polymère avec une ou plusieurs combinaisons métalliques identiques ou différentes,
(c) application du système de polymère noyau-enveloppe, obtenu à l'étape (b) sous forme de film, sur au moins un côté d'un substrat, de telle sorte que le système de polymère noyau-enveloppe est disposé dans le film en une structure régulière, et
(d) soumission du substrat obtenu à l'étape (c) à un procédé d'attaque ionique réactif, un procédé de pulvérisation d'ions ou un procédé chimique par voie humide ou une combinaison de ces derniers, dans lequel le film appliqué sur le substrat est éliminé, et dans lequel la structure régulière produite par le système de polymère noyau-enveloppe est convertie en une structure en relief du substrat, à cause et en fonction du type de chargement des noyaux micellaires ainsi que de la durée du procédé d'attaque ionique réactif et/ou du procédé de pulvérisation d'ions et/ou du procédé chimique par voie humide.

6. Procédé selon la revendication 5, dans lequel, avant l'application sous forme de film ou après la formation du film, au moins une partie des combinaisons métalliques contenues dans les noyaux de polymère est convertie, par traitement chimique et/ou par rayonnement riche en énergie, en une ou plusieurs particules métalliques et/ou d'oxyde métallique dans chaque noyau de polymère individuel.

7. Procédé selon la revendication 5 ou 6, dans lequel au moins une partie des combinaisons métalliques contenues dans les noyaux de polymère est convertie en solution, par un procédé de réduction ou d'oxydation, en une ou plusieurs particules métalliques et/ou d'oxyde métallique dans chaque noyau de polymère individuel, de telle sorte qu'une partie des noyaux de polymère chargés contient un ou plusieurs atomes de métal et/ou une ou plusieurs combinaisons métalliques.

8. Procédé selon la revendication 7, dans lequel la réduction est effectuée en solution au moyen d'hydrazine.

9. Procédé selon l'une quelconque des revendications 5 à 8, dans lequel, à l'étape (d), on utilise un procédé de pulvérisation d'ions d'argon.

10. Procédé selon l'une quelconque des revendications 1 à 9, dans lequel le polymère est choisi parmi des copolymères en masse, des copolymères greffés, des polymères en étoile à micro-bras, des polymères en étoile avec des bras différents, des polymères dentritiques, des particules de micro-gel, des polymères en masse en forme d'étoile, des polymères en forme d'étoile en masse et des polymères de latex noyau-enveloppe.

11. Procédé selon la revendication 10, dans lequel le polymère est l'oxyde de polystyrène-b-polyéthylène, la polystyrène-b-poly(2-vinylpyridine), la polystyrène-b-poly(4-vinylpyridine) ou un mélange de ceux-ci.

12. Procédé selon l'une quelconque des revendications 1 à 11, dans lequel la combinaison métallique est choisie parmi des combinaisons de Au, Pt, Pd, Ag, In, Fe, Zr, Al, Co, Ni, Ga, Sn, Zn, Ti, Si et Ge dans les degrés d'oxydation correspondants ou des mélanges de ces derniers.

13. Procédé selon la revendication 12, dans lequel la combinaison métallique est choisie parmi HAuCl₄, MeAuCl₄, dans lequel Me représente un métal alcalin, H₂PtCl₆, Pd(Ac)₂, Ag(Ac), AgNO₃, InCl₃, FeCl₃, Ti(OR)₄, TiCl₄, TiCl₃, CoCl₃, NiCl₂, SiCl₄, GeCl₄, GaH₃, ZnEt₂, Al(OR)₃, Zr(OR)₄, Si(OR)₄, dans lequel R représente un reste alkyle en C₁-C₈ à chaîne droite ou ramifiée, le ferrocène, le sel de Zeise et SnBu₃H ou des mélanges de ceux-ci.

14. Procédé selon la revendication 13, dans lequel la combinaison métallique est HAuCl₄.

15. Procédé selon l'une quelconque des revendications 1 à 14, dans lequel le substrat est choisi parmi des métaux nobles, des verres oxydiques, des substrats mono ou multicristallins, des semi-conducteurs, des métaux avec ou sans surface passivée ou des isolants.

16. Procédé selon la revendication 15, dans lequel le substrat est choisi parmi Si, SiO₂, Pt, Au, GaAs, In_{y}GaAs, AlₓGaAs, Ge, SiₓN_{y}, SiₓGaAs, InP, InPSi, GaInAsP, le verre, le graphite, le diamant, le mica, SrTiO₃ ou leurs modifications dopées.

17. Procédé selon l'une quelconque des revendications précédentes, dans lequel, à l'étape (c), l'application du film est effectuée en mono- ou multicouches au trempé, par coulée, par projection par rotation ou par adsorption à partir d'une solution diluée.

18. Procédé selon la revendication 17, dans lequel l'application est effectuée en mono- ou multicouches par un procédé au trempé à partir d'une solution diluée.

19. Procédé selon la revendication 17 ou 18, dans lequel le film obtenu à l'étape (c) présente une épaisseur de couche de 5 à 800 nm.

20. Substrat décoré en surface dans le domaine du nanomètre, qui comporte à la surface des groupes d'atomes de métal et/ou de combinaisons métalliques, dans lequel les groupes sont disposés régulièrement sur la surface du substrat.

21. Substrat selon la revendication 20, dans lequel les groupes présentent un diamètre de 0,5 à 100 nm.

22. Substrat selon la revendication 20 ou 21, dans lequel les groupes sont disposés de manière régulière sur la surface du substrat avec un écartement allant jusqu'à 400 nm.

23. Substrat selon l'une quelconque des revendications 20 à 22, dans lequel les groupes sont constitués d'atomes de métal et/ou d'oxydes métalliques identiques ou différents.

24. Substrat selon la revendication 23, dans lequel les groupes sont constitués d'atomes d'or.

25. Substrat selon la revendication 23, dans lequel les groupes sont constitués de Au/F₂O₃, Au/CoO, Au/Co₃O₄, Au/ZnO, Au/TiO₂, Au/ZrO₂, Au/Al₂O₃, Au/In₂O₃, Pd/Al₂O₃, Pd/ZrO₂, Pt/graphite ou Pt/Al₂O₃.

26. Substrat selon l'une quelconque des revendications 20 à 25, dans lequel le substrat est choisi parmi Pt, Au, GaAs, In_{y}GaAs, AlₓGaAs, Si, SiO₂, Ge, SiₓN_{y}, SiₓGaAs, InP, InPSi, GaInAsP, le verre, le graphite, le diamant, le mica, SrTiO3 ou leurs modifications dopées.

27. Utilisation du substrat décoré en surface dans le domaine du nanomètre, selon l'une quelconque des revendications 20 à 26, pour époxydation d'alcènes en C₃ à C₈ ou pour oxydation de CO en CO₂.

28. Substrat structuré en surface pouvant être obtenu par un procédé selon l'une quelconque des revendications 5 à 19.

29. Substrat structuré en surface qui présente une structure en relief avec des dimensions latérales entre 1 et 100 nm au-dessus des domaines macroscopiques.

30. Substrat selon la revendication 29, qui est choisi parmi des métaux nobles, des verres oxydiques, des substrats mono- ou multicristallins, des semi-conducteurs, des métaux avec ou sans surface passivée ou des isolants.

31. Substrat selon la revendication 30, qui est choisi parmi Pt, Au, GaAs, In_{y}GaAs, AlₓGaAs, Si, SiO₂, Ge, SiₓN_{y}, SiₓGaAs, InP, InPSi, GaInAsP, le verre, le graphite, le diamant, le mica, SrTiO₃ ou leurs modifications dopées.
